(19) Europäisches Patentamt
European Patent Office
Office européen des brevets

(11) **EP 2 815 218 B1**

(12) **FASCICULE DE BREVET EUROPEEN**

(45) Date de publication et mention
de la délivrance du brevet:
**24.05.2023 Bulletin 2023/21**

(21) Numéro de dépôt: **13706205.5**

(22) Date de dépôt: **14.02.2013**

(51) Classification Internationale des Brevets (IPC):
**G01J 3/50** (2006.01)        **G01J 3/02** (2006.01)
**G01J 3/12** (2006.01)

(52) Classification Coopérative des Brevets (CPC):
**G01J 3/50; G01J 3/0272; G01J 3/506;
H01L 27/14601;** G01J 2003/1282

(86) Numéro de dépôt international:
**PCT/EP2013/053000**

(87) Numéro de publication internationale:
**WO 2013/120956 (22.08.2013 Gazette 2013/34)**

(54) **PROCEDE ET DISPOSITIF DE MESURE DE LA COULEUR D'UN OBJET**

VERFAHREN UND VORRICHTUNG ZUR MESSUNG DER FARBE EINES OBJEKTS

METHOD AND DEVICE FOR MEASURING THE COLOUR OF AN OBJECT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.02.2012 FR 1251484
18.05.2012 FR 1254559
31.07.2012 FR 1257403**

(43) Date de publication de la demande:
**24.12.2014 Bulletin 2014/52**

(73) Titulaire: **Color Grail Research
75013 Paris (FR)**

(72) Inventeur: **HENNEBELLE, Franck
75013 Paris (FR)**

(74) Mandataire: **Lavoix
2, place d'Estienne d'Orves
75441 Paris Cedex 09 (FR)**

(56) Documents cités:
**GB-A- 2 474 701**

- **STEPHEN K. PARK ET AL: "Estimation of spectral reflectance curves from multispectral image data", APPLIED OPTICS, vol. 16, no. 12, 1 décembre 1977 (1977-12-01), page 3107, XP055006711, ISSN: 0003-6935, DOI: 10.1364/AO.16.003107**

- **TSUKADA M ET AL: "An approach to color constancy using multiple images", PROCEEDINGS / THIRD INTERNATIONAL CONFERENCE ON COMPUTER VISION : DECEMBER 4 - 7, 1990, OSAKA, JA; [PROCEEDINGS OF THE INTERNATIONAL CONFERENCE ON COMPUTER VISION], IEEE COMPUTER SOC. PRESS, LOS ALAMITOS, CALIF, vol. CONF. 3, 4 December 1990 (1990-12-04) , pages 385-389, XP010020080, DOI: 10.1109/ICCV.1990.139557 ISBN: 978-0-8186-2057-7**

- **OHTA Y ET AL: "Recovery of illuminant and surface colors from images based on the CIE daylight", ELECTRONIC PUBLISHING, ARTISTIC IMAGING, AND DIGITAL TYPOGR; [LECTURE NOTES IN COMPUTER SCIENCE , ISSN 0302-9743], SPRINGER VERLAG, DE, vol. 801/2, 2 May 1994 (1994-05-02), pages 235-246, XP009130679, ISBN: 978-3-540-24128-7**

- **J Ho ET AL: "Separating a color signal into illumination and surface reflectance components: theory and applications", IEEE Transactions on Pattern Analysis and Machine Intelligence, 1 October 1990 (1990-10-01), pages 966-977, XP55572385, DOI: 10.1109/34.58869 Retrieved from the Internet: URL:https://ieeexplore.ieee.org/ielx1/34/2 141/00058869.pdf?tp=&arnumber=58869&isnum b er=2141**

**Description**

**Domaine de l'invention**

La présente invention se rapporte au domaine de la mesure de la couleur.

La présente invention se rapporte plus particulièrement à un procédé de spectrométrie pour mesurer la couleur d'un objet mettant en oeuvre un dispositif électronique, et au dispositif associé.

**Etat de la technique**

Une couleur est un flux lumineux perçu par l'oeil humain. Il s'agit d'une distribution spectrale d'énergie $C(\lambda)$ sur une bande de longueurs d'onde, en l'occurrence $\lambda$ variant de 380 à 780 nm pour le visible (observateur standard CIE 1931). Dans la suite, nous désignerons par une lettre et un $\lambda$ entre parenthèses la fonction qui décrit cette distribution spectrale d'énergie.

Du fait de la synthèse additive, toute couleur peut être exprimée par ses coordonnées trichromatiques selon trois couleurs primaires. Il existe plusieurs systèmes de primaires, nous retiendrons dans la suite les deux normalisés que sont l'espace CIE XYZ (et sa variante CIE Yxy avec plan de chromacité à luminance constante) et l'espace CIE L*a*b qui permet d'estimer une différence de couleur avec une norme euclidienne appelée « deltaE », qui est représentative des différences de couleur perçues par l'oeil humain. Le « gamut » (limites) de ces deux espaces couvre l'intégralité du visible humain. Nous ferons aussi référence à l'espace trichromatique sRGB correspondant au gamut de référence de la plupart des équipements électroniques actuels. Le gamut du sRGB ne couvre pas l'ensemble du visible humain, notamment dans les bleus-verts.

La couleur d'un objet résulte des interactions entre un flux lumineux incident et la surface dudit objet. Trois phénomènes entrent en concurrence pour donner à la matière l'apparence qu'on lui connaît : l'absorption, la réflexion spéculaire et la réflexion diffuse. La réflexion spéculaire se produit à la surface de l'objet. Il y a peu d'interaction de la lumière avec la matière de l'objet - et notamment ses pigments. La couleur de la lumière réfléchie est donc proche de la lumière reçue, mais l'énergie réfléchie est concentrée dans un lobe centré dans la direction théorique définie par les lois de Snell-Descartes. A contrario, la réflexion diffuse a lieu plus en profondeur. La lumière émise est teintée de la couleur des pigments et l'énergie réfléchie est indépendante de la direction d'observation. Autrement dit, la réflexion spéculaire est la composante brillante d'une surface et la réflexion diffuse est la composante matte et colorée d'une surface.

Par conséquent, la couleur d'un objet dépend de deux facteurs indépendants : l'éclairement auquel l'objet est soumis et la nature de la surface de l'objet. Cette dernière est caractérisée par la fonction de « réflectance spectrale bidirectionnelle ». Elle est définie comme le rapport entre la luminance réfléchie par la surface et l'éclairement de celle-ci. La valeur de cette fonction dépend de la longueur d'onde $\lambda$, de la direction de la lumière incidente et de la direction d'observation. La réflectance diffuse uniforme de l'objet $R^{OBJ}(\lambda)$, correspondant à la réflexion diffuse, ne dépend que de la longueur d'onde $\lambda$. C'est elle qui donne l'information de couleur au sens chromatique, hors phénomène de brillance.

C'est pourquoi la couleur d'un objet peut être caractérisée 1) par la lumière réfléchie sous un illuminant donné (par exemple les coordonnées trichromatiques CIE L*a*b sous un illuminant D50 dans une salle noire) ou, mieux, 2) par sa réflectance spectrale $R^{OBJ}(\lambda)$. La première méthode requiert des dispositifs de mesure relativement simples (entre autres, les nuanciers de couleurs, les colorimètres tri-stimulus), mais avec un fort risque de métamérisme (cette méthode est peu précise). Son utilisation est généralement restreinte au suivi des variations par rapport à une couleur étalon le long d'un processus de fabrication (imprimerie, textile, arts graphiques, etc.). La deuxième méthode nécessite des dispositifs plus sophistiqués (entre autres, spectromètre à diffraction, spectromètre à double-photorécepteurs en parallèle) ; elle n'est pas affectée par le métamérisme (cette méthode est très précise) et elle permet de simuler la perception de la couleur sous différents illuminants (intérieur, extérieur). Elle est destinée aux professionnels exigeants et aux activités de conception.

Tous ces dispositifs ne sont pas compatibles avec une utilisation nomade et non planifiée comme avec un téléphone portable ou une tablette électronique que l'on emmène partout. Leur usage est relativement compliqué, sans oublier le coût additionnel significatif qu'ils représentent.

A contrario, les applications de mesure de la couleur disponibles actuellement sur les téléphones portables ou tablettes (iOS, Android...) ne nécessitent pas un équipement annexe spécialisé, mais ces applications ne permettent pas une mesure fidèle des couleurs. En effet, elles reposent uniquement sur l'utilisation du capteur d'image couleur de l'appareil (réseau de photodétecteurs tri-stimulus, matrice de Bayer rouge-vert-bleu) avec un programme de calcul de la balance des blancs. Leur perception des couleurs des objets est donc faussée par la variabilité inconnue de l'éclairage environnant.

L'art antérieur connaît le spectromètre émissif à diffraction et un procédé de détermination de la fonction de réflectance spectrale de l'objet : le dispositif produit un illuminant étalonné blanc $S(\lambda)$ en direction de la cible, l'illuminant se réfléchit sur l'objet, puis passe à travers un prisme pour y être diffracté vers plusieurs dizaines de photodétecteurs (un par sous-spectre) qui permettent d'interpoler E(λ), d'où :

$$R^{OBJ}(\lambda) = E(\lambda)/S(\lambda)$$

Le fonctionnement de la mesure de couleur d'un objet avec ce procédé de l'art antérieur est réalisé avec un boîtier développé spécialement et avec un procédé nécessitant un cache pour masquer tout illuminant extérieur inconnu. De plus, ce type de spectromètre ne permet pas de réaliser une photographie spectrométrique.

L'art antérieur connaît, par le brevet américain N° US5963333, un spectromètre à LED et double photorécepteurs placés en parallèle, un boîtier de détection à spectromètre et un procédé de détermination de la fonction de réflectance spectrale de l'objet. La mesure de couleur d'un objet avec ce procédé de l'art antérieur est réalisée au moyen d'un boîtier développé spécialement et avec un procédé nécessitant un cache pour masquer tout illuminant extérieur inconnu. De plus, ce type de spectromètre ne permet pas de réaliser une photographie spectrométrique.

L'art antérieur connaît également, par la demande de brevet PCT N° WO 2004/079314, un colorimètre, un boîtier de détection à colorimètre et un procédé de détermination de la couleur d'un objet en calculant un écart par rapport à une couleur étalon. Le fonctionnement de la mesure de couleur avec ce procédé de l'art antérieur est réalisé avec un boîtier développé spécialement, un procédé nécessitant un cache pour masquer tout illuminant extérieur inconnu, et un procédé incapable de mesurer une fonction de réflectance spectrale proprement dite.

L'art antérieur connaît également, par la demande de brevet britannique N° GB2474701A, un colorimètre, un boîtier de détection à colorimètre et un procédé de détermination de la couleur d'un objet en calculant un écart par rapport à une couleur étalon. La mesure de couleur avec ce procédé de l'art antérieur est réalisée au moyen d'un téléphone équipé d'un écran pour l'émission de flashs de couleur et d'un appareil photo sur la face opposée. La mesure de couleur avec ce procédé de l'art antérieur est réalisée avec des guides d'onde développés spécialement (jeux de miroir, fibres optiques, etc.), un procédé nécessitant un cache ou des guides d'onde pour masquer tout illuminant extérieur inconnu, et un procédé incapable de mesurer une fonction de réflectance spectrale proprement dite.

D'autres documents illustrant l'état de la technique sont les articles suivant :

- "An approach to color constancy using multiples images" de Masato Tsukada et al., IEEE 1990,
- "Recovery of illuminant and surface colors from images based on the CIE daylight" de Yuichi Ohta et al., Lecture notes in Computer Science, 1994,
- "Separating a color signal into illumination and surface réflectance components : theory and applications" de Jian Ho et al., IEEE 1990, et
- "Estimation of spectral réflectance curves from multispectral image data" de Stephen Park et al., Applied Optics 1977.

## Exposé de l'invention

La présente invention entend remédier aux inconvénients de l'art antérieur en proposant un procédé de mesure de la couleur d'un objet par spectrométrie utilisant comme émetteur un moyen apte à émettre des illuminants de couleurs, et comme récepteur un capteur électronique d'image couleur, les deux situés côte à côte, en présence ou non d'un illuminant extérieur inconnu (mais constant pour tous les flashs).

Dans le principe, la présente invention fonctionne à l'opposé d'un spectromètre émissif à diffraction : au lieu de générer un seul illuminant étalonné et de l'analyser avec plusieurs dizaines de photodétecteurs, la présente invention génère plusieurs dizaines d'illuminants étalonnés et les analyse avec simplement trois photodétecteurs.

A cet effet, la présente invention concerne, dans son acception la plus générale, un procédé de mesure de la réflectance diffuse uniforme $R^{OBJ}(\lambda)$ en au moins un point d'un objet, le procédé étant tel que défini dans la revendication 1.

Ainsi, le procédé selon la présente invention permet de mesurer précisément la réflectance diffuse uniforme d'un objet en au moins un point, et ceci de manière optimisée par rapport aux solutions décrites dans l'art antérieur. De plus, la présente invention fonctionne parfaitement avec des appareils nomades du quotidien.

Le procédé présente avantageusement une ou plusieurs des caractéristiques des revendications 2 à 12.

La présente invention se rapporte également à un dispositif selon la revendication 13.

## Brève description des dessins

On comprendra mieux l'invention à l'aide de la description, faite ci-après à titre purement explicatif, d'un mode de réalisation de l'invention, en référence aux Figures dans lesquelles :

- la Figure 1 illustre de façon schématique le dispositif selon la présente invention ; et

- la Figure 2 représente les différentes étapes du procédé selon la présente invention ;
- la Figure 3 décrit le non-recouvrement systématique des bandes de longueurs d'ondes intervenant dans le cadre du procédé selon la présente invention : oeil humain, capteur, source, mesure ; et
- les Figures 4, 5, 6, 7 et 8 illustrent l'algorithme de flashage, en l'occurrence la génération de grilles successives pour répartir de la façon la plus homogène possible N flashs au sein du triangle de flashage.

## Description détaillée des modes de réalisation de l'invention

A titre de remarque préliminaire, on notera que les notations dans ce paragraphe sont :

- capteur= capteur électronique d'images couleurs (la fonction vidéo n'est pas utilisée dans le cadre de l'étalonnage, seule est utilisée la prise d'images statiques),
- source= source des illuminants/flashs de couleurs (écran, diode(s), laser(s), etc.) ;
- $(R,G,B)^{source}{}_i$ = paramètres d'entrée non-linéaires de chrominance de la source des illuminants de couleurs (RGBW$^{source}{}_i$ ou RGBY$^{source}{}_i$ pour des dispositifs à 4 primaires et plus),
- $BL^{source}{}_i$ = paramètre d'entrée non-linéaire de luminance de la source des illuminants de couleurs (par exemple le rétroéclairage d'un écran LCD) ;
- $(R,G,B)^{capteur}{}_i$ = paramètres de sortie non linéaires de chrominance du flux lumineux capté par le capteur d'images couleurs,
- $BV^{capleur}$ = paramètre de sortie non linéaire de luminance du flux lumineux capté par le capteur d'images couleurs (par exemple la Brightness Value de la norme japonaise EXIF) ;
- OBJ = objet de couleur à mesurer ;
- EXT = illuminant extérieur environnant ;
- R/G/B = équation valable pour chaque primaire rouge (red) ou verte (green) ou bleue (blue);
- OBJ/EXT = équation valable pour l'objet de couleur ou pour l'illuminant extérieur ;
- $x/y/z(\lambda)$ = équation valable pour chaque sensibilité spectrale $x(\lambda)$, $y(\lambda)$ et $z(\lambda)$ ;
- sensibilités spectrales de l'observateur standard CIE 1931 = $x^{EC\_CIE\text{-}1931}(\lambda)$, $y^{EC\_CIE\text{-}1931}(\lambda)$, $z^{EC\_CIE\text{-}1931}(\lambda)$ pour $\lambda \in$ [380 nm ;780 nm] ;
- sensibilités spectrales du capteur électronique d'images couleur : $x^{EC\_capteur}(\lambda)$, $y^{EC\_capteur}(\lambda)$, $z^{EC\_capteur}(\lambda)$. Les notations en exposant EC_XXX signifient que l'on se situe dans l'espace colorimétrique XXX.

Dans les figures et l'exemple de réalisation décrit ci-dessous, le moyen 11 apte à émettre des couleurs est un écran émissif. Il est entendu que ce moyen 11 apte à émettre des couleurs peut également être une ou plusieurs diode(s) multicolore(s), un ou plusieurs laser(s) multicolore(s), un ou plusieurs flash(s) colorés ou tout autre moyen apte à émettre des « couleurs » (une « couleur » = une fonction spectrale d'énergie dans la gamme de longueur d'ondes considérée). En outre, dans les figures et l'exemple de réalisation décrits ci-dessous, la couleur de l'objet est réduite à la réflectance uniforme diffuse. Il est entendu que ledit procédé est apte à capter les autres composantes de réflectance, en particulier la réflectance spéculaire pour les objets brillants et satinés via l'affichage à l'écran d'une figure blanche sur fond noir et la détection du lobe de réflexion spéculaire résultant par une analyse de gradient dans le plan focal image du capteur d'images couleurs.

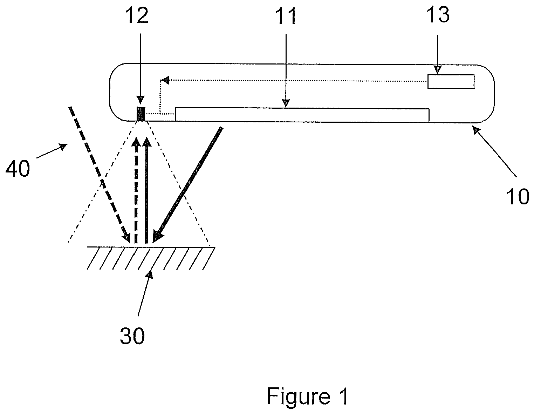

La Figure 1 représente sur une coupe schématique le dispositif 10 selon l'invention pour mesurer les couleurs d'un objet et de la lumière environnante extérieure : l'objet 30 à mesurer de couleur $R^{OBJ}(\lambda)$; le moyen apte à émettre des couleurs 11 capable d'émettre N illuminants connus $S^{source}(\lambda)_i$ ; la lumière environnante extérieure 40 $I^{EXT}(\lambda)$ ; le capteur électronique d'image couleurs 12 caractérisant en chrominance et luminance le flux lumineux réfléchi $E^{capteur}(\lambda)_i$ ; l'application informatique 13 « colorimétriquement pré-étalonnée » qui pilote l'ensemble et interagit avec l'opérateur.

Dans un mode de réalisation, l'application informatique 13 est partiellement ou totalement distribuée dans le réseau ou « nuage » (« cloud » en terminologie anglo-saxonne).

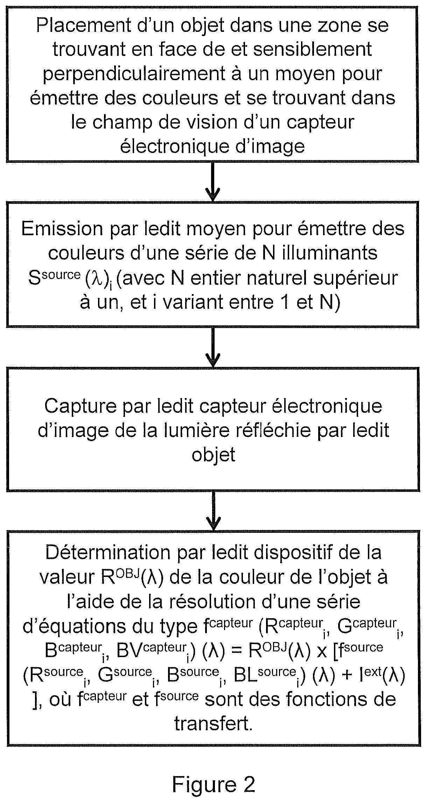

La Figure 2 représente les différentes étapes du procédé selon la présente invention :

- placement dudit objet 30 dans une zone se trouvant en face de et sensiblement perpendiculairement audit moyen 11 apte à émettre des illuminants de couleur sous la forme de flux lumineux de couleurs et se trouvant dans le champ de vision dudit capteur électronique d'images couleurs 12, ledit objet 30 étant également soumis à un illuminant extérieur sous la forme d'un flux lumineux extérieur environnant 40 $I^{ext}(\lambda)$ inconnu et constant où $\lambda$ désigne la longueur d'onde, émission par ledit moyen 11 d'une série de N illuminants $S^{source}(\lambda)_i$ (avec N entier naturel supérieur à un, i variant de 1 à N et $\lambda$, la longueur d'onde), $S^{source}(\lambda)_i$ étant connu en fonction des paramètres d'entrée dudit moyen 11 apte à émettre des flux lumineux de couleurs, capture par ledit capteur électronique d'images couleurs 12 du flux lumineux réfléchi en au moins un point dudit objet 30 et entrant dans le capteur, ledit flux lumineux étant noté $E^{capteur}(\lambda)_i$, avec N entier naturel strictement supérieur à deux, i variant de 1 à N et $\lambda$ la longueur d'onde, et obtention de N équations « $E_i$ » :

$$E^{capteur}(\lambda)_i = R^{OBJ}(\lambda)*(I^{ext}(\lambda)+S^{source}(\lambda)_i)$$

en raison du caractère additif de la lumière ondulatoire et par définition de la réflectance diffuse uniforme $R^{OBJ}(\lambda)$ en au moins un point de l'objet ; et

- détermination par ledit dispositif des deux fonctions inconnues continues $R^{OBJ}(\lambda)$ et $I^{ext}(\lambda)$ en résolvant le système des N équations $E_i$ :

  - en intégrant chaque équation $E_i$ sur l'intersection des spectres source et capteur, en notant x, y et z les sensibilités dans la base colorimétrique choisie, chaque équation $E_i$ générant alors trois équations « $E_i$ intégrée » :

$$\int E^{capteur}(\lambda)_i * x(\lambda) * d\lambda$$
$$= \int R^{OBJ}(\lambda) * (I^{ext}(\lambda) + S^{source}(\lambda)_i) * x(\lambda) * d\lambda$$

$$\int E^{capteur}(\lambda)_i * y(\lambda) * d\lambda$$
$$= \int R^{OBJ}(\lambda) * (I^{ext}(\lambda) + S^{source}(\lambda)_i) * y(\lambda) * d\lambda$$

$$\int E^{capteur}(\lambda)_i * z(\lambda) * d\lambda$$
$$= \int R^{OBJ}(\lambda) * (I^{ext}(\lambda) + S^{source}(\lambda)_i) * z(\lambda) * d\lambda$$

  - en calculant la valeur numérique correspondant au terme de gauche des équations $E_i$ intégrée à l'aide des paramètres de sortie du capteur numérique d'image ; et
  - en exprimant les deux fonctions inconnues continues $R^{OBJ}(\lambda)$ et $I^{ext}(\lambda)$ à l'aide d'un nombre fini de points d'interpolation $(\lambda_j, y_j)$ reliés par au moins une fonction d'interpolation $s(\lambda)$ pour conserver le caractère continu desdites fonctions inconnues continues $R^{OBJ}(\lambda)$ et $I^{ext}(\lambda)$, les $\lambda_j$ étant des longueurs d'onde choisies dans l'intersection des spectres source et capteur et étant des paramètres d'entrée du procédé, choisis pour minimiser le nombre de points d'interpolation à précision donnée ; et
  - en recherchant les paramètres yi des fonctions $R^{OBJ}(\lambda)$ et $I^{ext}(\lambda)$ qui minimisent le système de moindres carrés $\|A * X - B\|_2$ résultant des équations $E_i$ intégrées.

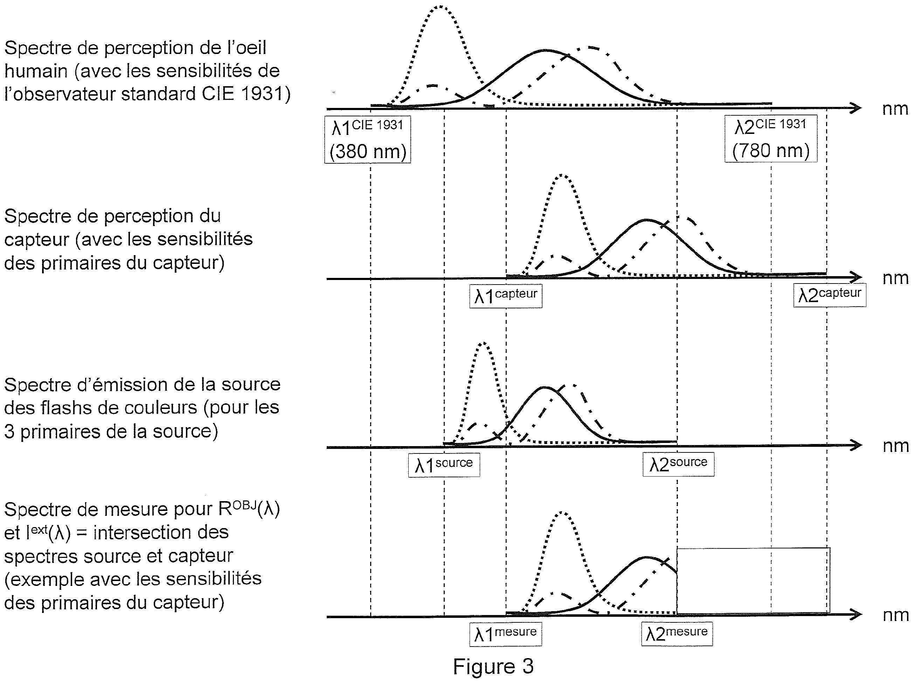

La Figure 3 décrit le non-recouvrement systématique des bandes de longueurs d'onde intervenant dans le procédé selon la présente invention :

- oeil humain : d'après la norme CIE 1931, il perçoit les flux lumineux entre $\lambda1^{CIE\ 1931}$ = 380 nm et $\lambda2^{CIE\ 1931}$ = 780 nm avec des sensibilités notées $x/y/z^{EC\_CIE\_1931}(\lambda)$ d'où l'espace colorimétrique $X/Y/Z^{EC\_CIE\_1931}$ par intégration sur $[\lambda1^{CIE\ 1931} ; \lambda2^{CIE\ 1931}]$ bien connu par l'homme de métier,
- Capteur : il perçoit les flux lumineux entre $\lambda1^{capteur}$ et $\lambda2^{capteur}$, avec des sensibilités notées $x/y/z^{EC\_capteur}(\lambda)$ d'où l'espace colorimétrique $XYZ^{EC\_capteur}$ par intégration sur $[\lambda1^{capteur} ; \lambda2^{capteur}]$, à l'instar de l'espace colorimétrique CIE 1931. Il est important de noter que la bande spectrale des capteurs électroniques d'images usuels (CCD, CMOS) couvre une partie d'infra-rouge, en plus du visible humain (sauf si présence d'un filtre infra-rouge)
- Source : la source émet des flashs de couleurs compris dans l'intervalle $[\lambda1^{source}; \lambda2^{source}]$ tels que : $\lambda1^{source} = min\left(\sum_{i=1}^{N} S^{source}(\lambda)_{i>0}\right)$ et $\lambda2^{source} = max\left(\sum_{i=1}^{N} S^{source}(\lambda)_{i>0}\right)$. Si la source est un écran LCD de téléphone portable, il est usuel que la bande spectrale couverte soit limitée à [300 nm ; 700nm], c'est-à-dire significativement moins large que celle de l'oeil humain [380 nm ; 780 nm]

- **mesure :** La mesure des fonctions $R^{OBJ}(\lambda)$ et $I^{ext}(\lambda)$ ne peut être réalisée que dans l'intersection des spectres de la source et du capteur que l'on note $[\lambda 1^{mesure} ; \lambda 2^{mesure}]$. En effet, d'une part, le capteur ne capte rien en dehors de son spectre d'intégration. D'autre part, la matrice $A^T*A$ doit être inversible ce qui est vérifié quand $\sum_{i=1}^{N} S^{source}(\lambda)_i > 0$ (cf. la fin de la description et l'annexe 2). Le choix de sensibilités x/y/z$^{EC\_mesure}(\lambda)>0$ sur $[\lambda 1^{mesure} ; \lambda 2^{mesure}]$ et nulles en dehors permet de créer un espace colorimétrique $XYZ^{EC\_mesure}$, à l'instar de l'espace colorimétrique CIE 1931. L'utilisation des sensibilités du capteur est toujours possible, celles de la norme CIE 1931 également si la bande $[\lambda 1^{mesure} ; \lambda 2^{mesure}]$ est incluse dans [380 nm ; 780 nm].

Une conséquence de la Figure 3 et des explications qui viennent d'être données est que le procédé selon l'invention est capable de déterminer les valeurs de la réflectance diffuse uniforme $R^{OBJ}(\lambda)$ et de l'illuminant extérieur $I^{ext}(\lambda)$ dans d'autres bandes spectrales que le visible humain, à condition que la source et le capteur soient compatibles avec ces bandes et que la « lumière » conserve un caractère ondulatoire : l'ultraviolet, les infrarouges, etc.

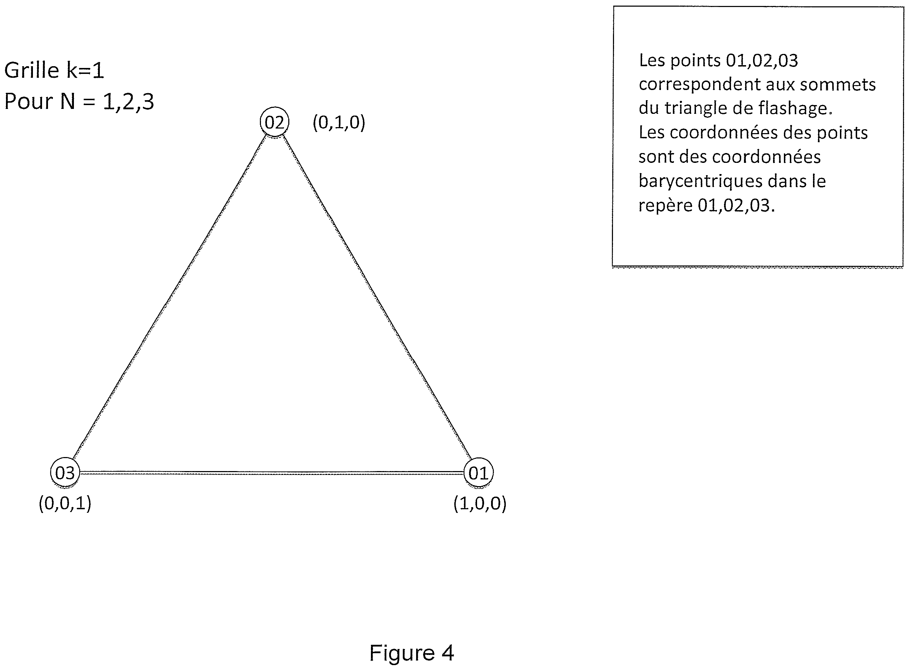

Les figures 4, 5, 6, 7 et 8 illustrent l'algorithme de flashage, en décrivant les grilles k utilisées en fonction d'un nombre croissant de flashs N demandés, pour répartir de la façon la plus homogène possible les flashs dans un triangle de flashage donné, compatible avec les gamuts source et capteur. La suite des grilles k est itérative quand N croît :

- La Figure 4 présente la grille k=1 à utiliser pour N compris entre 1 et 3. La position de chaque flash i est indiquée par son numéro ;

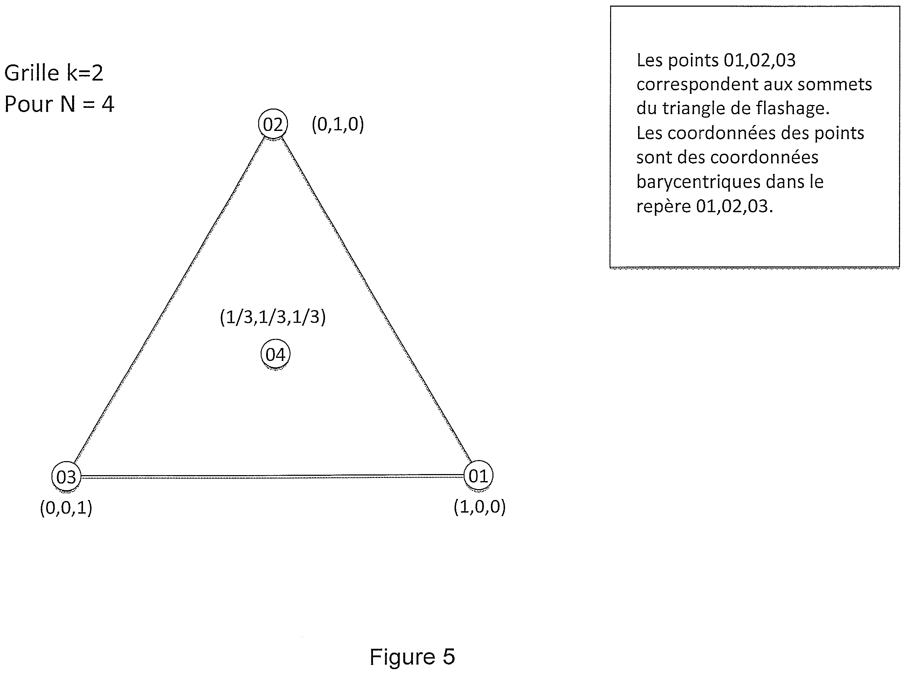

- La Figure 5 présente la grille k=2 à utiliser pour N=4. La position de chaque flash i est indiquée par son numéro ;

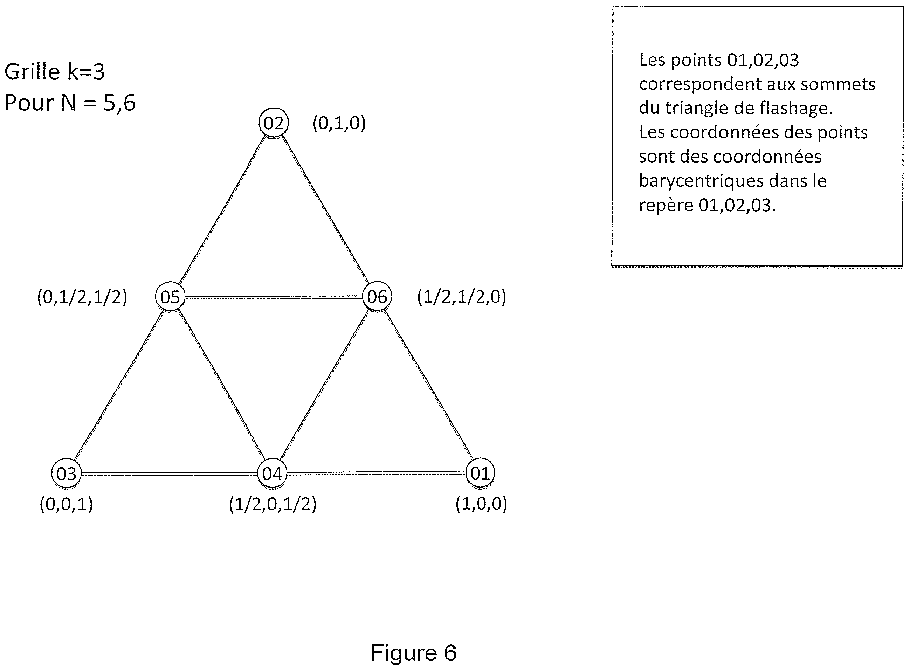

- La Figure 6 présente la grille k=3 à utiliser pour N compris entre 5 et 6. La position de chaque flash i est indiquée par son numéro ;

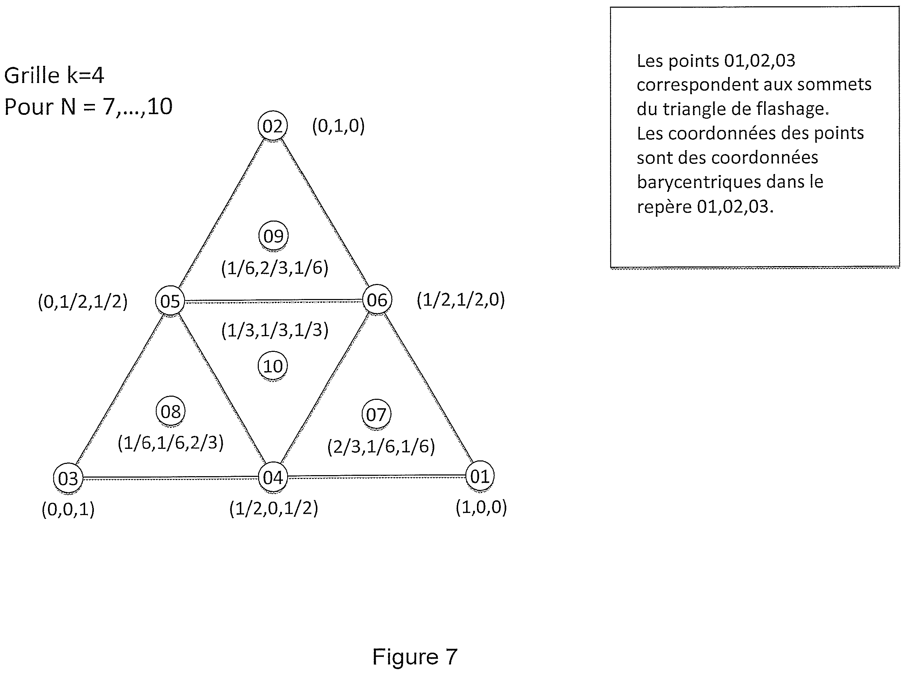

- La Figure 7 présente la grille k=4 à utiliser pour N compris entre 7 et 10. La position de chaque flash i est indiquée par son numéro ;

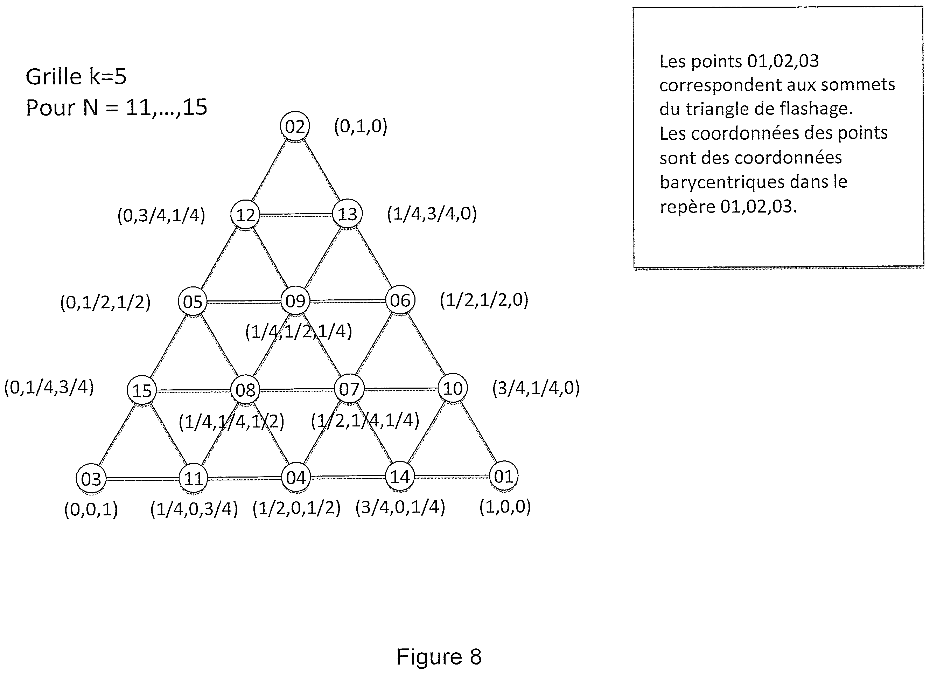

- La Figure 8 présente la grille k=5 à utiliser pour N compris entre 11 et 15. La position de chaque flash i est indiquée par son numéro.

Décrivons à présent le traitement pour déterminer les inconnues $R^{OBJ}(\lambda)$ et $I^{ext}(\lambda)$ à partir des N flashs de couleur.

Dans le mode de réalisation présenté Figure 1, l'objet à mesurer 30 est placé sous la source des flashs de couleurs 11 et dans le champ de vision du capteur électronique d'images couleurs 12.

Puis, la source 11 émet successivement une succession de flashs de couleurs en suivant l'algorithme de flashage décrit dans l'annexe 1 qui cherche à optimiser le conditionnement de la matrice A, en restant dans les gamuts écran et caméra et en s'assurant que l'illuminant extérieur reste constant au cours des flashs.

Cet algorithme prend en entrée un nombre de flashs N valides demandés. N dépend du nombre n de points d'interpolation demandés pour déterminer les fonctions $R^{OBJ}(\lambda)$ et $I^{ext}(\lambda)$. Au minimum, $3*N \geq (2n+2)$ pour que le système $A*X = B$ soit correctement déterminé (cf. fin de la description détaillée), donc $N \geq 2/3*(n+1)$.

L'algorithme de flashage renvoie en sortie une séquence de N flashs valides, avec pour chaque flash, les paramètres d'entrée de la source et les paramètres de sortie du capteur. L'indice de la séquence de flashs est noté i.

Nota : Si la précision requise pour déterminer les fonctions $R^{OBJ}(\lambda)$ et $I^{ext}(\lambda)$ est de l'ordre 10 nm, $N \approx n \approx 30$. Compte tenu de la réactivité des composants électroniques courants, l'ensemble du cycle de flashage prend une dizaine de secondes au maximum. Pour une cible non uniforme (par exemple une texture), le procédé utilise un algorithme de stabilisation d'image avec au moins un point de contraste.

Nota : Si la source des flashs de couleurs 11 est un écran émissif, elle est capable de générer un grand nombre de flashs de couleurs, typiquement N pouvant atteindre $2^{24}=16,7$ millions pour les systèmes RGB en 3x8 bits.

Pour chaque flash i, la lumière émise par la source 11 se reflète sur la cible colorée 30 puis elle arrive dans le capteur d'image 12 ce qui donne l'équation (Ei) :

$$E^{capteur}(\lambda)_i = R^{OBJ}(\lambda)*(S^{source}(\lambda)_i + I^{ext}(\lambda))$$

Développons l'équation $(E_i)$ :

$$E^{capteur}(\lambda)_i = R^{OBJ}(\lambda)*[S^{source}(\lambda)_i + I^{ext}(\lambda)] = R^{OBJ}(\lambda)*S^{source}(\lambda)_i + R^{OBJ}(\lambda)*I^{ext}(\lambda)$$

Posons $I^{EXT\ REF}(\lambda) = R^{OBJ}(\lambda)*I^{ext}(\lambda)$

L'équation ($E_i$) devient :

$$E^{capteur}(\lambda)_i = R^{OBJ}(\lambda)*S^{source}(\lambda)_i + I^{EXT\ REF}(\lambda)$$

Premièrement, le procédé va interpoler les fonctions $R^{OBJ}(\lambda)$ et $I^{EXT\ REF}(\lambda)$ à l'aide d'une fonction spline cubique scellée et de ($n^{OBJ/EXT\ REF}$ +1) points d'interpolation de coordonnées [$x_k = \lambda^{OBJ/EXT\ REF}{}_k$, $y_k = y^{OBJ/EXT\ REF}{}_k$] pour k=0 à $n^{OBJ/EXT\ REF}$ tels que :

- tous les $\lambda^{OBJ/EXT\ REF}{}_k$ sont compris dans l'intersection des spectres du capteur et de la source [$\lambda1^{mesure}$ ; $\lambda2^{mesure}$]

  (cf. Figure 3) avec $\lambda^{OBJ/EXT\ REF}{}_0 = \lambda1^{mesure}$ et $\lambda^{OBJ/EXT\ REF}_{n^{OBJ/EXT\ REF}} = \lambda2^{mesure}$ ;

- la pente nulle des splines est nulle aux extrémités: $p0 = p\ n^{OBJ/EXT\ REF} = 0$.

Les $y^{OBJ/EXT\ REF}{}_k$ sont les inconnues que le procédé va déterminer.

Comme les fonctions $R^{OBJ}(\lambda)$ et $I^{EXT\ REF}(\lambda)$ sont des fonctions splines scellées à pente nulle aux extrémités, $R^{OBJ}(\lambda)$ et $I^{EXT\ REF}(\lambda)$ peuvent s'écrire sous une forme linéaire :

$$R^{OBJ}(\lambda) = \sum_{k=0}^{n^{OBJ}} y^{OBJ}{}_k * \Phi^{OBJ}(l,k,\lambda) \quad (1)$$

$$I^{EXT\ REF}(\lambda) = \sum_{k=0}^{n^{EXT\ REF}} y^{EXT\ REF}{}_k * \Phi^{EXT\ REF}(l,k,\lambda) \quad (2)$$

avec :

- l entre 1 et $n^{OBJ/EXT\ REF}$ tel que : $\lambda_{l-1} < \lambda \leq \lambda_l$ et $l = 0$ si $\lambda = \lambda1^{mesure}$ ;

- $$\Phi^{OBJ/EXT\ REF}(l,k,\lambda) = a_k^{OBJ/EXT\ REF} + b_k^{OBJ/EXT\ REF} * (\lambda - \lambda_{l-1}) +$$
  $$c_k^{OBJ/EXT\ REF} * (\lambda - \lambda_{l-1})^2 * (\lambda - \lambda_l) + d_k^{OBJ/EXT\ REF} * (\lambda - \lambda_{l-1}) * (\lambda - \lambda_l)^2,$$

  pour k = 0 à $n^{OBJ/EXT}$ REF ;

- $a_k^{OBJ/EXT\ REF} = 0$ pour k = 0 à l-1 ;

- $a_{l-1}^{OBJ/EXT\ REF} = 1$ ;

- $a_l^{OBJ/EXT\ REF} = 0$ ;

- $a_k^{OBJ/EXT\ REF} = 0$ pour k = 1+1 à $n^{OBJ/EXT}$ REF ;

- $b_k^{OBJ/EXT\ REF} = 0$ pour k = 0 à l-1 ;

- $$b_{l-1}^{OBJ/EXT\ REF} = \frac{1}{\lambda_{l-1} - \lambda_l} \ ;$$

- $$b_l^{OBJ/EXT\ REF} = \frac{-1}{\lambda_{l-1} - \lambda_l} \ ;$$

- $b_k^{\text{OBJ/EXT REF}} = 0$ pour k = l+1 à n$^{\text{OBJ/EXT REF}}$$_k$ ;

- $$c_k^{\text{OBJ/EXT REF}} = \frac{\alpha_{l,k}^{\text{OBJ/EXT REF}}}{h_{l-1}^{\text{OBJ/EXT REF}^2}}$$

pour k = 0 à l-1 ;

- $$c_{l-1}^{\text{OBJ/EXT REF}} = \frac{\alpha_{l,l-1}^{\text{OBJ/EXT REF}} - \frac{1}{\lambda_{l-1}-\lambda_l}}{h_{l-1}^{\text{OBJ/EXT REF}^2}} ;$$

- $$c_l^{\text{OBJ/EXT REF}} = \frac{\alpha_{l,l}^{\text{OBJ/EXT REF}} + \frac{1}{\lambda_{l-1}-\lambda_l}}{h_{l-1}^{\text{OBJ/EXT REF}^2}} ;$$

- $$c_k^{\text{OBJ/EXT REF}} = \frac{\alpha_{l,k}^{\text{OBJ/EXT REF}}}{h_{l-1}^{\text{OBJ/EXT REF}^2}}$$

pour k = 1+1 à n$^{\text{OBJ/EXT REF}}$ ;

- $$d_k^{\text{OBJ/EXT REF}} = \frac{\alpha_{l-1,k}^{\text{OBJ/EXT REF}}}{h_{l-1}^{\text{OBJ/EXT REF}^2}}$$

pour k = 0 à l-1 ;

- $$d_{l-1}^{\text{OBJ/EXT REF}} = \frac{\alpha_{l-1,l-1}^{\text{OBJ/EXT REF}} - \frac{1}{\lambda_{l-1}-\lambda_l}}{h_{l-1}^{\text{OBJ/EXT REF}^2}} ;$$

- $$d_l^{\text{OBJ/EXT REF}} = \frac{\alpha_{l-1,l}^{\text{OBJ/EXT REF}} + \frac{1}{\lambda_{l-1}-\lambda_l}}{h_{l-1}^{\text{OBJ/EXT REF}^2}} ;$$

- $$d_k^{\text{OBJ/EXT REF}} = \frac{\alpha_{l-1,k}^{\text{OBJ/EXT REF}}}{h_{l-1}^{\text{OBJ/EXT REF}^2}}$$

pour k = 1+1 à n$^{\text{OBJ/EXT REF}}$ ;
- $h_{l-1}^{\text{OBJ/EXT REF}} = \lambda_{l-1} - \lambda_l$ pour l = 1 à n$^{\text{OBJ/EXT REF}}$ ;
- les $\alpha_{l,k}^{\text{OBJ/EXT REF}}$ expriment la pente du spline au point l en fonction des y$^{\text{OBJ/EXT REF}}$$_k$ : $p_l^{\text{OBJ/EXT REF}} = \sum_{k=0}^{n^{OBJ/EXT\ REF}} \alpha_{l,k}^{\text{OBJ/EXT REF}} * y_k^{OBJ/EXT\ REF}$

Les $\alpha_{l,k}^{\text{OBJ/EXT REF}}$ sont calculés par l'inversion (par pivot) du système linéaire suivant, caractéristique des fonctions splines cubiques scellées ; ils sont uniquement fonction des $\lambda_l$ (l = 0 à n$^{\text{OBJ/EXT REF}}$) :

$$\frac{p_{l-1}^{OBJ/EXT\ REF}}{h_{l-1}^{OBJ/EXT\ REF}} + 2 * p_l^{OBJ/EXT\ REF} * \left(\frac{1}{h_{l-1}^{OBJ/EXT\ REF}} + \frac{1}{h_l^{OBJ/EXT\ REF}}\right) + \frac{p_{l+1}^{OBJ/EXT\ REF}}{h_l^{OBJ/EXT\ REF}}$$

$$=$$

$$= 3 * \left(\frac{y_{l-1}^{OBJ/EXT\ REF} - y_l^{OBJ/EXT\ REF}}{h_{l-1}^{OBJ/EXT\ REF} * (\lambda_{l-1} - \lambda_l)} + \frac{y_l^{OBJ/EXT\ REF} - y_{l+1}^{OBJ/EXT\ REF}}{h_l^{OBJ/EXT\ REF} * (\lambda_l - \lambda_{l+1})}\right)$$

pour $I = 1$ à $N^{OBJ/EXT\ REF}-1$

Deuxièmement, le procédé connaît la fonction de transfert de la source des flashs de couleurs $f^{source}$ qui donne les fonctions $S^{source}(\lambda)_i$ en fonction des paramètres d'entrée de la source en chrominance $(R,G,B)^{source}_i = (C^{source\ R/G/B}_i)$ et en luminance $BL^{source}_i = C^{source\ BL}_i$. Cette fonction de transfert est déterminée à partir des valeurs théoriques de sortie « usine » du dispositif électronique et/ou d'un étalonnage préalable à la mesure. Il est inutile de renouveler obligatoirement cet étalonnage avant chaque mesure de couleur. Cette fonction de transfert est également disponible pour les dispositifs à 4 primaires et plus (rouge-vert-bleu-blanc, rouge-vert-bleu-jaune, etc.).

A titre illustratif, une forme de la fonction de transfert de la source est la suivante en précisant que les dispositifs d'électronique grand public cherchent à respecter le standard sRGB

- $f^{source}(C^{source\ R/G/B/BL}_i)(\lambda) = S^{source}(\lambda)_i$
- $f^{source}(C^{source\ R/G/B/BL}_i)(1) = C^{source\ BL\ linéaire\ i} *(S^{source}(\lambda)_i^R + S^{source}(\lambda)_i^G + S^{source}(\lambda)_i^B)$ ;
- $C^{source\ BL\ linéaire\ i} = (a^{source\ BL} * C^{source\ BL}_i + b^{source\ BL})^{\gamma^{source\ BL}} + C^{source\ BL}$
- $S^{source}(\lambda)_i^{R/G/B} = C^{source\ R/G/B\ linéaire\ i} * S^{source}(\lambda)^{R/G/B\ MAX}$
- $C^{source\ R/G/B\ linéaire\ i} = (a^{source\ R/G/B} * C^{source\ R/G/B}_i + b^{source\ R/G/B})^{\gamma^{source R/G/B}} + C^{source\ R/G/B}$

Troisièmement, le procédé connaît la fonction de transfert du capteur électronique d'image couleur $f^{capteur}$ qui donne les coordonnées trichromatiques $(X,Y,Z)^{EC\_mesure}_i$ dans l'espace colorimétrique de mesure, du flux lumineux $E^{capteur}(\lambda)_i$ entrant dans le capteur, en fonction de ses paramètres de sortie de chrominance $(R,G,B)^{capteur}_i = C^{capteur\ R/G/B}_i$ et de luminance $BV^{capteur}_i = C^{capteur\ BV}$. Cette fonction de transfert est déterminée à partir des valeurs théoriques de sortie « usine » du dispositif électronique et/ou d'un étalonnage préalable à la mesure. Il est inutile de renouveler obligatoirement cet étalonnage avant chaque mesure de couleur.

A titre illustratif, une forme de la fonction de transfert du capteur électronique d'image couleur est la suivante en précisant que les dispositifs d'électronique grand public cherchent à respecter le standard sRGB :

- Luminance Y: Le procédé extrait de l'EXIF la BrightnessValue $BV^{capteur}$ pour calculer la luminance $B^{capteur}$ du flux lumineux entrant ($Bv = Log_2(B/N/K)$ en $cd/cm^2$) avec $N=1/3,125$ et $K=10,7$, puis le procédé détermine la luminance $Y = K*B$ ($K$ est un paramètre d'étalonnage résultant de pertes diverses: dispersion de la lumière de l'écran, absorption de la lentille, etc.)
- Chrominance $(x,y)^{EC\_mesure}$ : premièrement, le procédé linéarise les 3 coordonnées $(RGB)^{capteur}$ à l'aide d'une fonction paramétrique $y(g,a,b)$ $(f(x)=(a*x+b)^g)$ et il obtient les 3 coordonnées $(RGB\_linéaire)^{EC\_capteur}$. Deuxièmement, le procédé convertit les 3 $(RGB\_linéaire)^{EC\_capteur}$ en 3 coordonnées $(RGB\_raw)^{Ec\_capteur}$ par multiplication avec une matrice 3x3 $[WB^{capteur}]$ qui correspond aux valeurs de la balance des blancs. La balance des blancs consiste à réaliser une adaptation chromatique pour passer d'un blanc D65 (référence du sRGB) à un blanc estimé. Troisièmement, le procédé convertit les 3 coordonnées $(RGB\_raw)^{EC\_capteur}$ en 3 coordonnées $(X,Y,Z)^{Ec\_mesure}$ par multiplication avec la matrice de passage 3x3 $[p^{Ec\_capteur>Ec\_mesure}]$ qui correspond à un changement de base vectorielle pour passer de l'espace colorimétrique du capteur à un sous-espace vectoriel qui est l'espace colorimétrique de mesure. Quatrièmement, le procédé convertit les 3 coordonnées $(X,Y,Z)^{Ec\_mesure}$ en $(x,y)^{EC\_mesure}$.

Développons à présent les équations $(E_i)$ en les intégrant sur l'intersection des spectres du capteur et de la source $[\lambda 1^{mesure} ; \lambda 2^{mesure}]$ (cf. Figure 3) pour générer les équations « $E_i$ intégrées »:

$$\int_{\lambda 1^{mesure}}^{\lambda 2^{mesure}} E^{capteur}(\lambda)_i * x/y/z^{EC\_mesure}(\lambda) * d\lambda$$

$$= \int_{\lambda 1^{mesure}}^{\lambda 2^{mesure}} \left( R^{OBJ}(\lambda) * S^{source}(\lambda)_i + I^{EXT\,REF}(\lambda) \right) * x/y/z^{EC\_mesure}(\lambda) * d\lambda$$

$$f^{capteur}\left( C^{capteur\,R/G/B/BV}\,_i \right) X/Y/Z^{EC\_mesure}$$

$$= \int_{\lambda 1^{mesure}}^{\lambda 2^{mesure}} R^{OBJ}(\lambda) * f^{source} * \left( C^{source\,R/G/B/BL}\,_i \right)(\lambda) * x/y/z^{EC\_mesure}(\lambda) * d\lambda =$$

$$+ \int_{380\,nm}^{780\,nm} I^{EXT\,REF}(\lambda) * x/y/z^{EC\_mesure}(\lambda) * d\lambda$$

$$f^{capteur}\left( C^{capteur\,R/G/B/BV}\,_i \right) X/Y/Z^{EC\_mesure}$$

$$= \int_{\lambda 1^{mesure}}^{\lambda 2^{mesure}} \left( \sum_{k=0}^{n^{OBJ}} y^{OBJ}\,_k * \Phi^{OBJ}(l,k,\lambda) \right) * f^{source} * \left( C^{source\,R/G/B/BL}\,_i \right)(\lambda) * x/y/z^{EC\_mesure}(\lambda) * d\lambda$$

$$+ \int_{\lambda 1^{mesure}}^{\lambda 2^{mesure}} \left( \sum_{k=0}^{n^{EXT\,REF}} y^{EXT\,REF}\,_k * \Phi^{EXT\,REF}(l,k,\lambda) \right) * x/y/z^{EC\_mesure}(\lambda) * d\lambda$$

En permutant l'ordre des sommations, les équations (E$_i$ intégrées) deviennent :

$$f^{capteur}\left( C^{capteur\,R/G/B/BV}\,_i \right) X/Y/Z^{EC\_mesure}$$

$$= \sum_{k=0}^{n^{OBJ}} y^{OBJ}\,_k * \left( \int_{\lambda 1^{mesure}}^{\lambda 2^{mesure}} \Phi^{OBJ}(l,k,\lambda) * f^{source}\left( C^{source\,R/G/B/BL}\,_i \right)(\lambda) * x/y/z^{EC\_mesure}(\lambda) * d\lambda \right)$$

$$+ \sum_{k=0}^{n^{EXT\,REF}} y^{EXT\,REF}\,_k * \left( \int_{\lambda 1^{mesure}}^{\lambda 2^{mesure}} \Phi^{EXT\,REF}(l,k,\lambda) * x/y/z^{EC\_mesure}(\lambda) * d\lambda \right)$$

$$f^{capteur}\left( C^{capteur\,R/G/B/BV}\,_i \right) X/Y/Z^{EC\_mesure}$$

$$= \sum_{k=0}^{n^{OBJ}} y^{OBJ}\,_k * \left( \sum_{l=1}^{n^{OBJ}} \int_{\lambda_{l-1}}^{\lambda_l} \Phi^{OBJ}(l,k,\lambda) * f^{source}\left( C^{source\,R/G/B/BL}\,_i \right)(\lambda) * x/y/z^{EC\_mesure}(\lambda) * d\lambda \right)$$

$$+ \sum_{k=0}^{n^{EXT\,REF}} y^{EXT\,REF}\,_k * \left( \sum_{l=1}^{n^{EXT\,REF}} \int_{\lambda_{l-1}}^{\lambda_l} \Phi^{EXT\,REF}(l,k,\lambda) * x/y/z^{EC\_mesure}(\lambda) * d\lambda \right)$$

Posons $n^{OBJ+EXT\,REF} = (n^{OBJ} +1) + (n^{EXT\,REF} + 1)$;

Posons le vecteur $X^{OBJ+EXT\,REF}$ de dimension $n^{OBJ+EXT\,REF}$ tel que :

$(X^{OBJ+EXT\,REF})^T = (y^{OBJ}_0, ... \, y^{OBJ}_{n^{OBJ}}, y^{EXT\,REF}_0, ... \, y^{\,EXT\,REF}_{n^{\,EXT\,REF}})$ .

$(X^{OBJ+EXT\,REF})^T = (X^{OBJ+EXT\,REF}_1, ..., X^{OBJ+EXT\,REF}_{n^{\,OBJ+EXT\,REF}})$ ;

Posons les variables $(\Phi^{OBJ+EXT\,REF}_1(i,k^*,X/Y/Z^{EC\_mesure})$ telles que :

- si $1 \leq k \leq n^{OBJ}+1$ :

$$\Phi^{OBJ+EXT\,REF}(i,k',X/Y/Z^{EC\_mesure})$$

$$= \sum_{l=1}^{n^{OBJ}} \int_{\lambda_{l-1}}^{\lambda_l} \Phi^{OBJ}(l,k-1,\lambda) * f^{source}\left(C^{ECR\,R/V/B/BL}{}_i\right)(\lambda) * \quad x/y/z^{EC\_mesure}(\lambda) \quad * d\lambda$$

- si $n^{OBJ}+2 \leq k' \leq n^{OBJ}+n^{EXT\,REF}+2$ :

$$\Phi^{OBJ+EXT\,REF}(i,k',X/Y/Z^{EC\_mesure})$$

$$= \sum_{l=1}^{n^{EXT\,REF}} \int_{\lambda_{l-1}}^{\lambda_l} \Phi^{EXT\,REF}(l,k-n^{OBJ}-2,\lambda) * x/y/z^{EC\_mesure}(\lambda) \quad * d\lambda$$

Les équations ($E_i$ intégrées) peuvent s'écrire sous la forme des 3*N équations suivantes avec comme seules inconnues les $X^{OBJ+EXT\,REF}{}_k$ :

$$f^{capteur}\left(C^{capteur\,R/G/B/BV}{}_i\right)X/Y/Z^{EC\_mesure} = \sum_{k=1}^{n^{OBJ+EXT\,REF}} X_k^{OBJ+EXT\,REF} * \quad \Phi^{OBJ+EXT\,REF}\ (i,\ k,\ X/Y/Z^{EC\_mesure})\ ;$$

Posons la matrice jacobienne A de dimension (3*N ; $n^{OBJ+EXT\,REF}$) :

$$A = \begin{bmatrix} \Phi^{OER}(1,1,X) & \cdots & \Phi^{OER}(1,k',X) & \cdots & \Phi^{OER}(1,n^{OER},X) \\ \vdots & & & \vdots & \vdots \\ \Phi^{OER}(i,1,X) & \cdots & \Phi^{OER}(i,k',X) & \cdots & \Phi^{OER}(i,n^{OER},X) \\ \Phi^{OER}(i,1,Y) & \cdots & \Phi^{OER}(i,k',Y) & \cdots & \Phi^{OER}(i,n^{OER},Y) \\ \Phi^{OER}(i,1,Z) & \cdots & \Phi^{OER}(i,k',Z) & \cdots & \Phi^{OER}(i,n^{OER},Z) \\ \vdots & \cdots & & & \\ \Phi^{OER}(3*N,1,Z) & & \Phi^{OER}(3*N,k',Z) & \cdots & \Phi^{OER}(3*N,n^{OER},Z) \end{bmatrix}$$

Avec :

- OER pour « OBJ+EXT REF », de sorte que $\Phi^{OER}$ signifie $\Phi^{OBJ+EXT\,REF}$ et $n^{OER}$ signifie $n^{OBJ+EXT\,REF}$.

Posons le vecteur B égal à $f^{capteur}(C^{capteur\,R/G/B/BV}{}_i)\,X/Y/Z^{EC\_mesure}$ de dimension 3*N (i compris entre 1 et N).

Les équations (Ei intégrées) forment alors le système linéaire A*X = B.

Le procédé va utiliser l'algorithme des moindres carrés linéaires pour minimiser $||A * X - B||_2$. Le minimum est atteint pour : $Xmin = (A^T.A)^{-1}.A^T.B$, d'où les valeurs des points d'interpolation de $R^{OBJ}(\lambda)$ et $I^{EXT\,REF}(\lambda)$ et donc

$$I^{EXT}(\lambda) = \frac{R^{OBJ}(\lambda)}{I^{EXT\,REF}(\lambda)}$$

Il existe 3 conditions à respecter : on montre que la matrice $A^T.A$ est inversible si et seulement si A est injective, ce qui est vrai avec $\sum_{l=1}^{N} S^{source}(\lambda)_i > 0$ sur l'intervalle [$\lambda 1^{mesure}$ ; $\lambda 2^{mesure}$] et avec h = max ( $\lambda_{k+1} - \lambda_k$ ) suffisamment petit. La démonstration mathématique est décrite dans l'annexe 2. De plus, $X^{OBJ+EXT\,REF} \geq 0$ pour tous les k car ce sont les ordonnées de flux d'énergie.

La première condition est vérifiée par construction de [$\lambda 1^{mesure}$ ; $\lambda 2^{mesure}$] comme intersection des spectres source et capteur (voir Figure 3) et, la deuxième, avec un minimum de points d'interpolation pour $R^{OBJ}(\lambda)$ et $I^{EXT}(\lambda)$.

Concernant la troisième condition, la recherche de Xmin est réalisée sous contrainte $X^{OBJ+EXT\,REF} \geq 0$ pour tous les k, en utilisant, entre autres, l'algorithme NLLS de Lawson et Hanson (Laboratoire JET de la NASA, Solving Least Squares Problems aux éditions SIAM), ou, plus généralement, un algorithme d'optimisation quadratique.

Nota : Le procédé est envisageable avec d'autres fonctions d'interpolation en mode linéaire ou non-linéaire. Le mode non-linéaire est également à considérer pour passer d'un système de 3*N équations selon les composantes X/Y/Z$^{EC\_mesure}$ à un système de N équations sous forme de normes de type euclidienne ($||.. ||_2$) ou de type deltaE des coordonnées $(X,Y,Z)^{EC\_mesure}$.

Nota : Le procédé fonctionne, d'une part, avec des capteurs donnant accès aux coordonnées (R,G,B_raw) et, d'autre part, avec des capteurs ne donnant pas accès aux coordonnées (R,G,B_raw), ne donnant pas accès aux valeurs de la matrice de balance des blancs, mais permettant de verrouiller ces valeurs de balance des blancs pendant le processus de flashage. Dans ce deuxième cas, les valeurs de la matrice des blancs deviennent des inconnues supplémentaires à déterminer (9 au maximum). Pour résoudre ce système A*X=B augmenté des inconnues de balance des blancs, la technique consiste à augmenter le nombre de flashs pour disposer d'un système sur-déterminé, puis à le résoudre soit en mode non linéaire, soit en mode linéaire itératif de la façon suivante (entre autres quand les valeurs possibles des paramètres de la balance des blancs sont compris dans un ensemble fini de valeurs discrètes) : décomposition QR du système avec 2 blocs (X I balance des blancs), détermination de X avec le premier bloc en émettant une hypothèse sur les paramètres de balance des blancs, injection des valeurs de X dans le deuxième bloc, détermination des paramètres de balances des blancs, puis réinjection dans le premier bloc pour itérer X, et ainsi de suite.

Deux modes de réalisation de visée sont possibles pour l'invention en mode « colorimètre » afin d'enrichir l'expérience utilisateur et d'améliorer la précision du mode « nuancier » de l'invention :

- Premier mode de réalisation : écran 11 pointant à l'opposé des yeux de l'utilisateur

- Second mode de réalisation : écran 11 pointant dans la direction des yeux de l'utilisateur

**Premier mode de réalisation : écran pointant à l'opposé des yeux de l'utilisateur**

L'écran 11 affiche une figure blanche sur fond noir (rond/bandes/carré...) pour matérialiser l'endroit à viser, puis l'utilisateur appuie sur le déclencheur utilisé normalement pour prendre une photo (cf. bouton sur le côté pour un iPhone S ou sur le bas de l'écran à l'opposé de la position de la caméra de visioconférence).

Un intérêt particulier de ce premier mode de réalisation est d'être peu sensible à l'environnement lumineux ce qui garantit le fonctionnement de l'invention dans pratiquement tous les lieux usuels, même très lumineux (intérieur, extérieur). Cette qualité repose sur la très courte distance entre la cible, l'écran 11 et le capteur d'image 12, sur la forte luminosité des écrans émissifs et sur le fait qu'il existe plusieurs « barrages » de fait aux rayons lumineux environnants : support de l'écran et du capteur d'image, main/doigt(s) de l'utilisateur sur les côtés.

**Second mode de réalisation : écran pointant dans la direction des yeux de l'utilisateur**

L'écran 11 est posé face à l'illuminant extérieur, typiquement face au ciel. L'utilisateur vient alors placé sur le haut de l'écran l'objet coloré à mesurer (partie proche du capteur d'image). Pour faciliter la manoeuvre, l'écran 11 est divisé en deux parties, la partie supérieure proche du capteur d'image 12 sert à émettre les flux lumineux pour la mesure, la partie inférieure sert à donner une boucle de retour à l'utilisateur sur l'endroit qui est pointé (wysiwyg).

Un intérêt particulier de ce second mode de réalisation est de pouvoir mesurer la réflectance de l'écran R$^{ecran}(\lambda)$.

Le dispositif 10 selon la présente invention permet de transformer en spectromètre tous les équipements électroniques disposant d'un écran émissif 11 et d'un capteur d'image 12 situé b côté, entre autres les téléphones, les tablettes, les PDA (assistants personnels), les ordinateurs et les moniteurs/TV équipés d'une caméra de visioconférence. Il s'adresse aussi par exemple aux appareils photos et les caméscopes disposant d'un écran orientable/amovible.

Le dispositif 10 selon la présente invention permet d'ouvrir de nouveaux usages nomades de mesure fidèle de couleur absolue au quotidien, sans nécessiter un appareil dédié. La liste suivante n'est pas limitative :

- la mesure des couleurs sur des objets en tout genre matériaux, liquides, gaz, peintures, tapisseries, graphismes, textiles, plastiques, bois, métaux, sols, minéraux, végétaux et aliments... ;
- l'utilisation de codes-barres en couleur (à une ou plusieurs dimensions) ;
- la mesure des couleurs à but médical ou cosmétique sur l'homme et le vivant : peau, boutons, grains de beauté, chevelure, pelage, maquillage, dents... ;
- la mesure des couleurs dans un but d'assistance aux personnes daltoniennes et aveugles ;
- la mesure de la couleur d'objet(s) apparaissant sur une photographie afin de réaliser l'adaptation chromatique et de guider l'algorithme de balance des blancs è la place d'utiliser une mire de couleurs étalonnées annexe.

L'invention est décrite dans ce qui précède à titre d'exemple. Il est entendu que l'homme du métier est à même de réaliser différentes variantes de l'invention sans pour autant sortir du cadre du brevet.

## ANNEXE 1: ALGORITHME DE FLASHAGE

### Introduction

La présente annexe définit un algorithme de flashage visant à optimiser le conditionnement de la matrice A en cherchant à écarter au maximum les dits flashs et à les distribuer de la façon la plus homogène possible dans l'espace colorimétrique de mesure, tout en restant dans les gamuts de la source et du capteur électronique d'image et tout en s'assurant que l'illuminant extérieur reste constant au cours des flashs.

### Description de l'algorithme de flashage

Ledit algorithme prend en entrée un nombre de flashs N valides demandés.
Ledit algorithme renvoie en sortie une séquence de N flashs valides (avec pour chaque flash, les paramètres d'entrée de la source et les paramètres de sortie du capteur. L'indice de cette séquence est noté i (flash_i).
Ledit algorithme interagit avec le procédé et le dispositif selon l'invention qui émettent des flashs de couleurs vers un objet cible et qui captent la lumière réfléchie avec un capteur électronique d'image (entre autres, un smartphone avec l'écran qui émet les flashs et la caméra de visioconférence qui capte la lumière réfléchie par l'objet-cible).
Ledit algorithme fonctionne en présence d'un illuminant extérieur $I^{ext}(\lambda)$.
L'algorithme se décompose en 4 grandes « phases », et chaque phase en « étapes » :

- Phase 1 : émission d'un flash « noir 1 »

- Phase 2 : recherche des 3 sommets qui maximisent le « triangle de flashage »

- Phase 3 : complétion homogène du nombre de flashs valides demandés

- Phase 4 : émission d'un flash « noir 2 »

Notation : dans les lignes qui suivent, les coordonnées (dispR%, dispG%, dispB%) désignent les paramètres d'entrée de chrominance de la source des flashs de couleurs en pourcentage ([0;1]). DispBL% désigne le paramètre d'entrée de luminance de la source des flashs de couleurs en pourcentage ([0 ;1]). Dans la pratique, ce sont des valeurs binaires, variant généralement entre 0 et 255. (dispECMY, dispECMx, dispECMy) désignent les coordonnées du flux lumineux émis par la source dans l'espace colorimétrique $Yxy^{EC\_mesure}$.
Notation : dans les lignes qui suivent, les coordonnées (camR%_k, camG%_k, camB%_k) désignent les paramètres de sortie de chrominance du capteur électronique d'image en pourcentage ([0;1]). Dans la pratique, ce sont des valeurs binaires, variant généralement entre 0 et 255. camBv désigne la Brightness Value qui est le paramètre de sortie de luminance du capteur électronique d'image (cf. standard EXIF). (camECMX, camECMY, camECMZ) et (camECMY, camECMx, camECMy) désignent les coordonnées du flux lumineux émis par la source respectivement dans l'espace colorimétrique $XYZ^{EC\_mesure}$ et dans son diagramme de chromaticité.
Notation : dans les lignes qui suivent, les valeurs dispEps et camEps signifient que les valeurs de seuil au-deçà desquelles les valeurs d'entrée de la source et de sortie du capteur sont considérées comme nulles.

### Phase 1 : Emission d'un flash « noir 1 »

L'objectif de la phase 1 est double : contrôler que l'illuminant extérieur est compatible avec les limites physiques du dispositif et contrôler que l'illuminant extérieur est constant au cours du flashage.
L'algorithme émet un flash « noir », c'est-à-dire qu'il procède à une mesure avec la source éteinte, i.e. dispR% = dispG% = dispB% = 0 (et dispBL= 0 si possible).
L'algorithme est confronté à 2 cas possibles :

- Cas 1 : La valeur camECMY est strictement supérieure à une limite camECMY_IEmax définie en fonction de la luminance maximale de la source des flashs de couleurs, ce qui signifie que la luminance de l'illuminant extérieur est trop forte par rapport aux limites physiques de la source des flashs de couleurs. La mesure n'est pas possible. L'algorithme interrompt le processus de flashage en générant un code- erreur ;
- Cas 2: La valeur camECMY est inférieure ou égale à une limite camECMY_IEmax définie en fonction de la luminance maximale de la source des flashs de couleurs, ce qui signifie que la luminance de l'illuminant extérieur est compatible avec les limites physiques de la source des flashs de couleurs. L'algorithme stocke en mémoire les valeurs de chrominance et de luminance mesurées par le capteur d'images couleurs afin de s'assurer que l'illuminant reste constant au cours du flashage, puis l'algorithme passe à l'étape 1 de la phase 2.

Nota : dans la présente annexe 1, il n'est mentionné que 2 flashs noirs pour contrôler la constance de l'illuminant extérieur, un premier au début du flashage et un second à la fin. En fonction des conditions d'emploi du dispositif selon l'invention, il est tout à fait possible de réduire ou d'augmenter le nombre de flashs noirs pour contrôler la constance de l'illuminant extérieur.

**Phase 2: Recherche des 3 sommets qui maximisent le « triangle de flashaqe »**

L'objectif de la phase 2 est de construire un « sous-gamut de flashage » de taille maximale pour une précision donnée, en restant compatible avec le gamut de la source des flashs lumineux et celui du capteur électronique d'images.
Définissons la fonction f : (dispECMx, dispECMy) → (camECMx, camECMy) du gamut de la source des flashs de couleurs vers le gamut du capteur électronique d'images.
Le « sous-gamut source-capteur » est défini comme étant l'intersection du gamut du capteur et de l'image par f du gamut de la source. Le sous-gamut source est défini comme étant l'image réciproque par f du sous-gamut capteur.
Autrement dit, l'objectif de la phase 2 est de déterminer un triangle inclus dans le « sous-gamut capteur-source » de taille maximale pour une précision donnée. Ce triangle est appelé « triangle de flashage ».

**Etape 1: Recherche d'un pivot**

L'objet de l'étape 1 est de définir un flash-pivot à l'intérieur du gamut capteur.
L'algorithme va à l'étape 1.1 en utilisant une valeur pré-définie de flash- pivot pour l'itération k=1, par exemple un flash blanc de luminance maximale ($dispR\%_1 = dispG\%_1 = dispB\%_1 = dispBL\%_1 = 1$).

**Etape 1.1 : Essai d'un flash-pivot k**

L'objet de l'étape 1.1 est de tester si le flash-pivot proposé d'indice k est b l'intérieur du gamut capteur.
L'algorithme demande à la source de générer le flash-pivot k et il récupère les coordonnées de sortie du capteur ($camR\%_k$, $camG\%_k$, $camB\%_k$, $camBv_k$).
L'algorithme est confronté à 2 cas possibles :

- Cas 1.1-1 : Au moins une des composantes ($camR\%_k$, $camG\%_k$, $camB\%_k$) est inférieure ou égale à camEps, ce qui signifie que le flash est en dehors du gamut du capteur. L'algorithme va à l'étape #1.2
- Cas 1.1-2 : Toutes les composantes ($camR\%_k$, $camG\%_k$, $camB\%_k$) sont strictement supérieure à camEps, ce qui signifie que le flash est l'intérieur du gamut du capteur. L'algorithme va à l'étape 2

**Etape 1.2: Génération d'un nouveau flash-pivot d'indice k+1**

L'objet de l'étape 1.2 est de générer un nouveau flash-pivot d'indice k+1 l'intérieur du gamut capteur contrairement au flash-pivot précédent d'indice k.
L'algorithme est confronté à 2 cas possibles en fonction de ($camR\%_k$, $camG\%_k$, $camB\%_k$) :

- Cas 1.2-1 : Une seule des trois composantes ($camR\%_k$, $camG\%_k$, $camB\%_k$) est nulle avec le flash-pivot k. L'algorithme va essayer alors un nouveau flash-pivot (k+1) avec une proportion plus importante de la composante qui s'est annulée. A titre d'illustration, si $camR\%_k < camEps$, alors :

$$dispR\%_{k+1} = \alpha * dispR\%_k$$

$$dispG\%_{k+1} = dispG\%_k * \frac{1 - \alpha * dispR\%_k}{dispG\%_k + dispB\%_k}$$

$$dispB\%_{k+1} = dispB\%_k * \frac{1 - \alpha * dispR\%_k}{dispG\%_k + dispB\%_k}$$

$$avec\ 1 < \alpha < \frac{1}{dispR\%_k}$$

L'algorithme va à l'étape 1.1 avec ce flash-pivot k+1

- Cas 1.2-1 : Deux des trois composantes sont nulles (camR$\%_k$, camG$\%_k$, camB$\%_k$). L'algorithme va essayer alors un nouveau flash-pivot (k+1) avec une proportion plus importante des deux composantes qui se sont annulées. A titre d'illustration, si camR$\%_k$ < camEps et camG$\%_k$ < camEps, alors

$$dispR\%_{k+1} = \alpha * dispR\%_k$$

$$dispG\%_{k+1} = \beta * dispG\%_k$$

$$dispB\%_{k+1} = 1 - \alpha * dispR\%_k - \beta * dispG\%_k$$

avec

$$\alpha > 1, \beta > 1\ et\ \alpha * dispR\%_k + \beta * dispG\%_k < 1$$

L'algorithme va à l'étape 1.1 avec ce flash-pivot k+1
- Cas 1.2-3 : l'algorithme ne peut pas trouver de nouveau flash pivot k+1. Alors l'algorithme déclare la mesure impossible et sort de l'algorithme en renvoyant un code-erreur.

**Etape 2: Raccourci pour passer du flash-pivot à un premier triangle de flashage de grande taille**

L'objet de l'étape 2 est d'économiser des flashs pour faire grandir la taille du triangle de flashage autour du flash-pivot.

Pour ce faire, l'algorithme dispose d'une base de données avec en entrée des valeurs d'entrée et de sortie de flashs de référence et en sortie les coordonnées des triangles de flashage associés. Cette base de données est donc un raccourci pour faire grandir le triangle de flashage.

Plus précisément, l'algorithme encadre le flash-pivot avec les 3 flashs de référence les plus proches (au sens d'une norme euclidienne dans l'espace de mesure). Puis il mixe les coordonnées des triangles de flashage de référence en utilisant les coordonnées barycentriques du flash-pivot dans le triangle des 3 flashs de référence. L'algorithme obtient de la sorte un triangle de flashage de grande taille autour du flash-pivot. Il opère ensuite une homothétie de rapport K<1 sur ce triangle par rapport au flash-pivot pour prendre une marge de sécurité et il demande à la source d'émettre les 3 flashs de couleur correspondant aux 3 sommets dudit triangle. L'algorithme va ensuite à l'étape 4.1 pour analyser les résultats.

Si l'algorithme n'est pas capable d'encadrer le flash-pivot avec 3 flashs de référence, il sélectionne le flash de référence le plus proche de la base de données (si ce dernier est suffisamment proche par rapport à un seuil paramétrable) puis il fait émettre les 3 flashs comme précédemment et il va à l'étape 4.

S'il n'existe aucun flash de référence suffisamment proche dans la base de données, l'algorithme passe à l'étape 3.

**Etape 3: Passage du flash-pivot à un premier triangle de flashage de petite taille**

L'objet de l'étape 3 est de créer un premier triangle de flashage de petite taille grâce à trois points, le premier étant la sortie capteur pour le flash-pivot (camR$\%_k$, camG$\%_k$, camB$\%_k$).

L'algorithme ordonne les valeurs (camR$\%_k$, camG$\%_k$, camB$\%_k$), puis génère deux nouveaux flashs, le premier comportant plus (en proportion) de la composante la plus faible, le deuxième comportant plus des deux composantes les plus faibles.

A titre d'illustration, si camG$\%_k$ < camR$\%_k$ < camB$\%_k$, l'algorithme émet un premier flash comportant plus (en proportion) de composante verte, puis un deuxième flash comportant plus de composante verte et plus de composante rouge.

**Etape 3.1 : Essai du triangle de flashage de petite taille**

L'objet de l'étape 3.1 est de tester si le triangle de flashage de petite taille est inclus dans le gamut capteur.

L'algorithme est confronté à 3 cas possibles

- Cas 3.1-1 : au moins un flash sort du gamut capteur. L'algorithme va à l'étape 3.2.
- Cas 3.1-2: les sorties capteur pour ces flashs sont alignés avec la sortie capteur pour le flash-pivot. L'algorithme déclare la mesure impossible et sort de l'algorithme en renvoyant un code-erreur.
- Cas 3.1-3: le triangle de flashage de petite taille est inclus dans le gamut capteur et les points ne sont pas alignés. L'algorithme va à l'étape 4.

**Etape 3.2: Génération d'un nouveau triangle de flashaqe de petite taille**

L'objet de l'étape 3.2 est de générer un nouveau triangle de flashage de petite taille en remplaçant les flashs dont la sortie capteur est sortie du gamut capteur.
L'algorithme remplace le (ou les) flash(s) qui a (ont) échoué en ajoutant moins des composantes ajoutées. L'algorithme va à l'étape 3.1 avec cette nouvelle base.

**Etape 4: Maximisation de la taille du triangle de flashage**

L'objet de l'étape 4 est de construire le triangle de flashage de taille maximale pour une précision donnée.
La transformation f est supposée linéaire et l'algorithme détermine cette transformation grâce aux données des 3 points de la base du gamut capteur. L'algorithme en déduit le sous-gamut source-capteur puis détermine le triangle de surface maximale inclus dans ce sous-gamut. Il opère ensuite une homothétie de rapport K<1 sur ce triangle par rapport au flash-pivot pour prendre une marge de sécurité et il demande à la source d'émettre les 3 flashs de couleur correspondant aux 3 sommets dudit triangle. L'algorithme va ensuite à l'étape 4.1 pour analyser les résultats.

**Etape 4.1 : Essai d'un triangle de flashaqe d'ordre k**

L'objet de l'étape 4.1 est de tester si le triangle de flashage est inclus dans le gamut capteur.
L'algorithme est confronté à 2 cas possibles :

- Cas 4.1-1 : un sommet du triangle de flashage sort du gamut capteur. L'algorithme va à l'étape 4.2.
- Cas 4.1-2: le triangle de flashage est considéré comme insuffisamment grand, car au moins un de ses sommets est trop éloigné du sommet du gamut capteur le plus proche (au sens de la norme euclidienne dans l'espace de mesure), et le flash correspondant à ce sommet est également trop éloigné du sommet du gamut source le plus proche. L'algorithme va à l'étape 4.3.
- Cas 4.1-3 : le triangle de flashage est satisfaisant. L'algorithme passe à la phase 3.

**Etape 4.2: Génération d'un nouveau sommet d'indice k+1 du triangle de flashaqe suite à une sortie du gamut capteur du sommet d'indice k**

L'objet de l'étape 4.2 est de générer un nouveau sommet d'indice k+1 du triangle de flashage à l'intérieur du gamut capteur contrairement au sommet d'indice k et de coordonnées ($camR\%_k$, $camG\%_k$, $camB\%_k$).
L'algorithme est confronté à 2 cas possibles en fonction de ($camR\%_k$, $camG\%_k$, $camB\%_k$) :

- Cas 4.2-1 : Une seule des trois composantes ($camR\%_k$, $camG\%_k$, $camB\%_k$) est nulle. L'algorithme va essayer alors un nouveau flash-pivot (k+1) avec une proportion plus importante de la composante qui s'est annulée. A titre d'illustration, si $camR\%_k$ < camEps, alors

$$dispR\%_{k+1} = \alpha * dispR\%_k$$

$$dispG\%_{k+1} = dispG\%_k * \frac{1 - \alpha * dispR\%_k}{dispG\%_k + dispB\%_k}$$

$$dispB\%_{k+1} = dispB\%_k * \frac{1 - \alpha * dispR\%_k}{dispG\%_k + dispB\%_k}$$

*avec*

$$1 < \alpha < \frac{1}{dispR\%_k}$$

L'algorithme va à l'étape 1.1 avec ce flash-pivot k+1.

- Cas 4.2-2 : Deux des trois composantes sont nulles (camR%$_k$, camG%$_k$, camB%$_k$). L'algorithme va essayer alors un nouveau flash-pivot (k+1) avec une proportion plus importante des deux composantes qui se sont annulées. A titre d'illustration, si camR%$_k$ < camEps et camRG%$_k$ < camEps,

$$dispR\%_{k+1} = \alpha * dispR\%_k$$

$$dispG\%_{k+1} = \beta * dispG\%_k$$

$$dispB\%_{k+1} = 1 - \alpha * dispR\%_k - \beta * dispG\%_k$$

*avec*

$$\alpha > 1, \beta > 1 \ et \ \alpha * dispR\%_k + \beta * dispG\%_k < 1$$

L'algorithme va à l'étape 1.1 avec ce flash-pivot k+1.

- Cas 4.2-3: l'algorithme ne peut pas trouver de nouveau flash pivot k+1. Alors l'algorithme déclare la mesure impossible et sort de l'algorithme en renvoyant un code-erreur.

**Etape 4.3: Génération d'un nouveau sommet du triangle de flashage car triangle de flashaqe de taille insuffisante**

L'objet de l'étape 4.3 est d'agrandir le triangle de flashage car au moins un de ses sommets est trop éloigné du sommet du gamut capteur le plus proche et le flash flash_k_1 correspondant à ce sommet est également trop éloigné du sommet du gamut source le plus proche.

On note flash_k_2 et flash_k_3 les deux flashs dont les sorties capteur sont les deux autres sommets du triangle de flashage.

L'algorithme génère deux flashs respectivement barycentre du système {(flash flash_k_1, $\alpha$), (flash flash_k_2, 1-$\alpha$)} et barycentre du système {(flash flash_k_1, $\alpha$), (flash flash_k_3, 1-$\alpha$)} (par ex : $\alpha$ = 0.2). Ces deux flashs et le flash flash_k_1 forment un triangle sur lequel la transformation f est supposée affine. L'algorithme déterminer cette transformation grâce aux données des trois points et en déduit le sous-gamut source-capteur puis détermine le sommet qui permet d'obtenir le triangle de flashage de surface maximale inclus dans ce sous-gamut. Il opère ensuite une homothétie de rapport K<1 sur ce point par rapport au sommet précédent pour prendre une marge de sécurité et il demande à la source d'émettre le flash de couleur correspondant au dit point. Si la sortie capteur sort du gamut capteur, l'algorithme réitère l'opération avec une marge supérieure (K plus petit), sinon, la sortie capteur remplace le sommet précédent et forme avec les autres sommets un nouveau triangle de flashage. L'algorithme va à l'étape 4.1 avec ce nouveau triangle de flashage.

**Phase 3: Complétion homogène du nombre de flashs valides demandés**

L'objectif de la phase 3 est de générer une séquence de N flashs dont les sorties capteur sont répartis de façon homogène dans le triangle de flashage défini lors de la phase 2.

L'algorithme dispose donc des coordonnées des sommets du triangle de flashage ainsi que d'un certain nombre de flashs intermédiaires qui ont permis de déterminer le triangle de flashage lors de la phase 2 (au moins un : le flash-pivot). Ces points sont notés (camECMx_k, camECMy_k).

**Etape 1: Génération d'une grille de N points dans le triangle de flashage**

L'objet de l'étape 1 est de générer une grille de N points répartis de façon homogène dans le triangle de flashage.

L'algorithme génère une grille de N points répartis comme décrit sur les figures 4 à 8 pour des valeurs de N allant de 1 à 15.

L'algorithme va à l'étape 2 avec cette grille de N points dans le triangle de flashage, notés (camECMx_g_k, camECMy_g_k).

**Etape 2: Génération d'un flash**

L'objet de l'étape 2 est de générer des flashs dont la sortie capteur se rapproche des points idéaux situés sur la grille défini lors de l'étape 1.

Pour chaque point (camECMx_g_k, camECMy_g_k), l'algorithme détermine le triangle de sommets trois points non alignés (camECMx_k, camECMy_k) qui minimise la somme des carrés des distances du point (camECMx_g_k, camECMy_g_k) aux sommets du triangle. Cette somme est appelée distance au triangle.

L'algorithme choisit le point (camECMx_g_k, camECMy_g_k) dont la distance à son triangle est la plus petite.

La transformation f est supposée linéaire sur ce triangle et son voisinage, et on la détermine grâce aux données des 3 sommets du triangle. L'algorithme détermine ainsi le flash (dispECMx_g_k, dispECMy_g_k) dont la sortie capteur sera (camECMx_g_k, camECMy_g_k).

Si la sortie capteur pour le flash (dispECMx_g_k, dispECMy_g_k) sort du gamut capteur, le flash n'est pas retenu.

Le point (camECMx_g_k, camECMy_g_k) est supprimé de la liste des points à approcher.

L'algorithme est confronté à 2 cas possibles :

- Cas 2-1 : il ne reste plus aucun point (camECMx_g_k, camECMy_g_k) à approcher. L'algorithme va à l'étape #3 avec l'ensemble des flashs qui ont été générés au cours de phase 2 et 3.
- Cas 2-2: il reste encore au moins un point (cam ECMx_g_k, camECMy_g_k) à approcher. L'algorithme va à l'étape 2 avec la nouvelle liste de points (camECMx_g_k, camECMy_g_k).

**Etape 3: Choix des flashs à retourner**

L'algorithme ne retient que les flashs dont la sortie capteur est suffisamment proche d'un point de la grille générée à l'étape 1 (au sens de la distance euclidienne dans l'espace colorimétrique de mesure). Si deux points sont suffisamment proches d'un point de la grille, alors n'est retenu que le point le plus proche. L'algorithme passe ensuite à la phase 4.

Nota : si au moins un flash dont la sortie capteur est strictement incluse dans le gamut capteur est retenu, alors la condition $\sum_{l=1}^{N} S^{source}(\lambda)_i > 0$ sur l'intervalle [$\lambda 1^{mesure}$ ; $\lambda 2^{mesure}$] utilisée dans la démonstration de l'inversibilité de $A^T{*}A$ en annexe 2 est vérifiée.

**Phase 4 : Emission d'un flash « noir 2»**

L'objectif de la phase 4 est de contrôler que l'illuminant extérieur est constant au cours du flashage.

L'algorithme émet un flash « noir », c'est-à-dire qu'il procède à une mesure avec la source éteinte, i.e. dispR% = dispG% = dispB% = 0 (et dispBL = 0 si possible).

L'algorithme est confronté à 2 cas possibles :

- Cas 1 : La différence des valeurs de chrominance et de luminance mesurées par le capteur d'images couleurs entre le flash noir courant et le flash noir précédent est strictement supérieure à un seuil donné. Cela signifie que l'illuminant extérieur a varié au cours des flashs. L'algorithme interrompt le processus de flashage en générant un code-erreur ;
- Cas 2: La différence des valeurs de chrominance et de luminance mesurées par le capteur d'images couleurs entre le flash noir courant et le flash noir précédent est inférieure ou égale à un seuil donné. Cela signifie que l'illuminant extérieur n'a pas varié au cours des flashs et donc que le processus de flashage est valide. L'algorithme renvoie la séquence des N flashs valides réalisés avec, pour chaque flash, les paramètres d'entrée de la source et les paramètres de sortie du capteur.

**ANNEXE 2: DEMONSTRATION DE L'INVERSIBILITE DE $A^{T*}A$**

On montre que AT*A est inversible dans le cas où $\sum_{l=1}^{N} S^{source}(\lambda)_i > 0$ sur l'intervalle [$\lambda 1^{mesure}$ ; $\lambda 2^{mesure}$] (les flashs recouvrent l'ensemble des longueurs d'onde considérées pour déterminer $R^{OBJ}(\lambda)$ et $I^{ext}(\lambda)$), et pour h = max ($\lambda_{i+1}$ - $\lambda_i$) suffisamment petit.

Soit x un vecteur propre associé à la valeur propre $\mu$.

On a d'une part ($A^{T*}A.x$, x) = ($\mu.x,x$) = $\mu.$(x, x) = $\mu.||x||^2$

$$\text{Donc } \mu = \frac{||A.x||^2}{||x||^2}$$

Et d'autre part ($A^{T*}A.x$, x) = (A.x, A.x) = $||A. x||^2$

Donc $\mu$ est positive et elle l'est strictement si A est injective.

Donc si A est injective, toutes les valeurs propres de $A^{T*}A$ sont strictement positives, donc $A^{T*}A$ est inversible.

Réciproquement, si A n'est pas injective, il existe x non nul tel que A.x = 0.

On a alors $A^{T*}A.x$ = 0 donc $A^{T*}A$ n'est pas inversible.

Finalement, $A^{T*}A$ est inversible si et seulement si A est injective.

**Lemme 1: l'intégrale d'une spline S($\lambda$) cubique scellée à pentes nulles aux extrémités ∫ S($\lambda$)*d$\lambda$ est toujours positive quand tous les $y_j$ sont positifs**

Cas n°1: si tous les $y_j$ = 0,

Alors s($\lambda$)=0 pour tous les $\lambda$ en raison des pentes nulles aux bords, d'où ∫ S($\lambda$)*d$\lambda$ = 0

Cas n°2: s'il existe un $y_i$ >0 et que tous les autres $y_i$ sont nuls:

$y_i$ crée un "ventre positif" sur [$\lambda_{i-1}$ ; $\lambda_i$] $\cup$ [$\lambda_i$ ; $\lambda_{i+1}$] (aire > 0) et des "ventres négatifs" sur [$\lambda_{i-2}$ ; $\lambda_i$] $\cup$ [$\lambda_{i+1}$ ; $\lambda_{i+2}$] (aire < 0), et ainsi de suite jusqu'aux bords.

Comme la fonction spline minimise l'énergie de la languette, la surface du ventre positif sur [$\lambda_{i-1}$ ; $\lambda_i$] $\cup$ [$\lambda_i$ ; $\lambda_{i+1}$] est supérieure à celles des ventres négatifs [$\lambda_{i-2}$ ; $\lambda_i$] $\cup$ [$\lambda_{i+1}$ ; $\lambda_{i+2}$]. C'est dû au fait que $|p_{i+1}| > |p_{i+2}| > ... > |p_n| = 0$ et que $|p_{i-1}| > |p_{i-2}| > ... > |p_0| = 0$. Du coup, la surface des ventres positifs est plus grande que les ventres négatifs et donc ∫S($\lambda$)*d$\lambda$ > 0.

Cas n°3: s'il existe deux $y_i$>0:

Cas n°3.1: $y_i$ et $y_{i+1}$ > 0 (contigus) : Cela crée un "gros" ventre positif. Le raisonnement du cas n°2 est applicable
Cas n°3.2: $y_i$ et $y_{i+2}$ > 0 ($y_{i+1}$ = 0): on a 2 ventres positifs contigus. Le raisonnement du cas n°2 est applicable
Cas n°3.3: $y_i$ et $y_{i+3}$ > 0 ($y_{i+1}$ = $y_{i+2}$): on a 1 ventre positif, 1 ventre négatif, 1 ventre positif. Le raisonnement du cas n°2 est applicable
Cas n°3.4: $y_i$ et $y_{i+k}$>0 avec k>3. Idem cas n°3.3

Cas n°4: s'il existe au moins 3 $y_i$ > 0 (cas général).

Alors le raisonnement des cas n°3 est applicable. CQFD

**Lemme 2: l'intégrale d'une spline S($\lambda$) cubique scellée à pentes nulles aux extrémités multipliée par une fonction K($\lambda$)>0 (∫S($\lambda$)*K($\lambda$)*d$\lambda$) est toujours positive quand tous les $y_i$ sont positifs**

Le lemme 1 (cas n°2) n'est pas applicable directement car le terme K($\lambda$) peut diminuer fortement l'aire des ventres positifs et augmenter celle des ventres négatifs.

L'astuce consiste à augmenter le nombre de points d'interpolation pour diminuer la surface des ventres négatifs.

Replaçons-nous dans le cas n°2 du lemme 1. L'erreur d'une spline scellée est bornée par la formule suivante : $|f(x)-s(x)| \leq a*h^4$ avec a= 5/384*max[a;b]{|f(4)(E)|} > 0 (valeur constante) et h = max{|$x_i$ - $x_{i-1}$|}.

C'est-à-dire que: $f(x)-a*h \leq s(x) \leq f(x)-1-a*h$

Comme $f(x) \geq 0$ ($R^{OBJ}(\lambda)$ et $I^{EXT}(\lambda)$ sont des flux d'énergie), $s(x) \geq -a*h$, donc la surface maximale des ventres négatifs $[\lambda_{i-2} ; \lambda_i] \cup [\lambda_{i+1} ; \lambda_{i+2}]$ est égale à $-2*a*h^2$.

La surface des ventres positifs reste constante car l'augmentation du nombre de points d'interpolation va créer plusieurs $y_i > 0$ contigus.

Par conséquent, il existe un h pour lequel la surface des ventres positifs est strictement supérieure à celle des ventres négatifs.

**Retour à la démonstration**

Soit x tel que A*x=0 avec x formé des ordonnées des splines cubiques scellées à pentes nulles aux extrémités représentant $R^{OBJ}(\lambda)$ et $I^{EXT}(\lambda)$.

Montrons que x=0

On a pour tout i=1,..., N et pour toute sensibilité x/y/z($\lambda$) :

$$\int R^{OBJ}(\lambda) * S^{source}(\lambda)_i * x/y/z(\lambda) * d\lambda + \int I^{ext}(\lambda) * x/y/z(\lambda) * d\lambda$$

$$= 0$$

où $R^{OBJ}(\lambda)$ et $I^{EXT}(\lambda)$ sont les fonctions splines cubiques scellées à pentes nulles aux extrémités

En sommant pour les 3*N équations, on obtient :

$$\int R^{OBJ}(\lambda) * \sum_{i=1}^{N} S^{source}(\lambda)_i * \big(x(\lambda) + y(\lambda) + z(\lambda)\big) * d\lambda$$

$$+ \int I^{ext}(\lambda) * \big(x(\lambda) + y(\lambda) + z(\lambda)\big) * d\lambda = 0$$

avec $x(\lambda) + y(\lambda) + z(\lambda) > 0$ et $\sum_{i=1}^{N} S^{source}(\lambda)_i > 0$ pour tout $\lambda$, on déduit du lemme 2 qu'il existe un h suffisamment petit tel que :

$$\int R^{OBJ}(\lambda) * \sum_{i=1}^{N} S^{source}(\lambda)_i * \big(x(\lambda) + y(\lambda) + z(\lambda)\big) * d\lambda = 0$$

et $\int I^{ext}(\lambda) - (x(\lambda) + y(\lambda) + z(\lambda)) - d\lambda = 0$

Puisque $R^{OBJ}(\lambda) = 0$ et $I^{EXT}(\lambda) = 0$ pour tout $\lambda$, i.e. x = 0. A est injective. Donc $A^T*A$ est inversible. CQFD

**Revendications**

1. Procédé de mesure de la réflectance diffuse uniforme $R^{OBJ}(\lambda)$ en au moins un point d'un objet (30) à l'aide d'un dispositif (10) comportant un moyen (11) apte à émettre des illuminants de couleur exprimés sous la forme de flux lumineux et un capteur électronique d'images couleurs (12), **caractérisé en ce qu'**il comporte les étapes suivantes :

    • placement dudit objet (30) dans une zone se trouvant en face de et sensiblement perpendiculairement audit moyen (11) apte à émettre des illuminants de couleur sous la forme de flux lumineux de couleurs et se trouvant dans le champ de vision dudit capteur électronique d'images couleurs (12), ledit objet (30) étant également soumis à un illuminant extérieur sous la forme d'un flux lumineux extérieur environnant (40) $I^{ext}(\lambda)$ inconnu et constant où $\lambda$ désigne la longueur d'onde, émission par ledit moyen (11) d'une série de N illuminants $S^{SOURCE}(\lambda)_i$

avec N entier naturel strictement supérieur à un, i variant de 1 à N et $\lambda$, la longueur d'onde, $S^{SOURCE}(\lambda)_i$ étant connu en fonction des paramètres d'entrée dudit moyen (11) apte à émettre des flux lumineux de couleurs, capture par ledit capteur électronique d'images couleurs (12) du flux lumineux réfléchi en au moins un point dudit objet (30) et entrant dans le capteur, ledit flux lumineux étant noté $E^{capteur}(\lambda)_i$, avec N entier naturel strictement supérieur à deux, i variant de 1 à N et $\lambda$ la longueur d'onde, et obtention de N équations « $E_i$ »:

$$E^{capteur}(\lambda)_i = R^{OBJ}(\lambda)*(I^{ext}(\lambda)+S^{SOURCE}(\lambda)_i)$$

en raison du caractère additif de la lumière ondulatoire et par définition de la réflectance diffuse uniforme $R^{OBJ}(\lambda)$ en au moins un point de l'objet (30) ; et

• détermination par ledit dispositif (10) des deux fonctions inconnues continues $R^{OBJ}(\lambda)$ et $I^{ext}(\lambda)$ en résolvant le système des N équations $E_i$ :

- en intégrant chaque équation $E_i$ sur l'intersection des spectres source et capteur, en notant x, y et z les sensibilités dans la base colorimétrique choisie, chaque équation $E_i$ générant alors trois équations « $E_i$ intégrée » :

$$\int E^{capteur}(\lambda)_i * x(\lambda) * d\lambda$$

$$= \int R^{OBJ}(\lambda) * (I^{ext}(\lambda) + S^{SOURCE}(\lambda)_i) * x(\lambda) * d\lambda$$

$$\int E^{capteur}(\lambda)_i * y(\lambda) * d\lambda$$

$$= \int R^{OBJ}(\lambda) * (I^{ext}(\lambda) + S^{SOURCE}(\lambda)_i) * y(\lambda) * d\lambda$$

$$\int E^{capteur}(\lambda)_i * z(\lambda) * d\lambda$$

$$= \int R^{OBJ}(\lambda) * (I^{ext}(\lambda) + S^{SOURCE}(\lambda)_i) * z(\lambda) * d\lambda$$

- en calculant la valeur numérique correspondant au terme de gauche des équations $E_i$ intégrée à l'aide des paramètres de sortie du capteur numérique d'image ; et
- en exprimant les deux fonctions inconnues continues $R^{OBJ}(\lambda)$ et $I^{ext}(\lambda)$ à l'aide d'un nombre fini de points, dit points d'interpolation, chaque point d'interpolation associant à une longueur d'onde $\lambda_i$ un paramètre $y_i$, les points d'interpolations étant reliés par au moins une fonction d'interpolation $s(\lambda)$ de type spline cubique scellée pour conserver le caractère continu desdites fonctions inconnues continues $R^{OBJ}(\lambda)$ et $I^{ext}(\lambda)$, les $\lambda_i$ étant des longueurs d'onde choisies dans l'intersection des spectres source et capteur et étant des paramètres d'entrée du procédé, choisis pour minimiser le nombre de points d'interpolation à précision donnée ; et
- en recherchant les paramètres $y_i$ des fonctions $R^{OBJ}(\lambda)$ et $I^{ext}(\lambda)$ qui minimisent le système de moindres carrés $\|A * X - B\|_2$ résultant des équations $E_i$ intégrées avec X le vecteur regroupant les paramètres $y_i$ et A une matrice de Jacobi.

2. Procédé selon la revendication 1, **caractérisé en ce qu'**il comporte en outre une étape de détermination de la valeur de l'illuminant extérieur $I^{ext}(\lambda)$.

3. Procédé selon la revendication 1 ou 2, **caractérisé en ce que** le nombre de flashs est du même ordre de grandeur que le nombre de points d'interpolation pour déterminer les valeurs de la réflectance diffuse uniforme $R^{OBJ}(\lambda)$ en au moins un point de l'objet et de l'illuminant extérieur $I^{ext}(\lambda)$.

**4.** Procédé selon la revendication 1 ou 2, **caractérisé en ce qu'**il comporte une étape de détermination des valeurs de la réflectance diffuse uniforme $R^{OBJ}(\lambda)$ en au moins un point de l'objet (30) et de l'illuminant extérieur $I^{ext}(\lambda)$ dans plusieurs bandes spectrales.

**5.** Procédé selon l'une quelconque des revendications précédentes, **caractérisé en ce que** ledit dispositif (10) met en oeuvre un écran pour émettre les flashs de couleur et un capteur électronique d'image pour capter la lumière réfléchie par l'objet-cible.

**6.** Procédé selon l'une quelconque des revendications précédentes, **caractérisé en ce que** ledit dispositif (10) est un appareil photo ou une caméra avec flash intégré ou amovible.

**7.** Procédé selon l'une quelconque des revendications précédentes, **caractérisé en ce que** ledit dispositif (10) met en oeuvre des guides d'onde pour faire transiter l'émission et la réception des flashs de couleurs.

**8.** Procédé selon l'une quelconque des revendications 1 à 7, **caractérisé en ce qu'**il est mis en oeuvre pour réaliser des photographies spectrométriques d'objets et pour réaliser des adaptations chromatiques à volonté.

**9.** Procédé selon l'une quelconque des revendications 1 à 7, **caractérisé en ce qu'**il est mis en oeuvre pour mesurer la couleur d'un élément compris dans le groupe suivant : matériaux, solides, liquides, gaz, peintures, tapisseries, graphismes, textiles, plastiques, bois, métaux, sols, minéraux, végétaux et aliments.

**10.** Procédé selon l'une quelconque des revendications 1 à 7, **caractérisé en ce qu'**il est mis en oeuvre pour la mesure des couleurs à but médical ou cosmétique sur l'homme et le vivant d'au moins un élément compris dans le groupe suivant : peau, boutons, grains de beauté, chevelure, pelage, maquillage, et dents.

**11.** Procédé selon l'une quelconque des revendications 1 à 7, **caractérisé en ce qu'**il est mis en oeuvre pour l'utilisation de codes-barres en couleur, à une ou plusieurs dimensions.

**12.** Procédé selon l'une quelconque des revendications 1 à 7, **caractérisé en ce qu'**il est mis en oeuvre dans un but d'assistance aux personnes daltoniennes et/ou aveugles.

**13.** Dispositif (10) comportant un moyen (11) apte à émettre des illuminants de couleur sous la forme de flux lumineux de couleurs et un capteur électronique d'images couleurs (12), de mesure de la réflectance diffuse uniforme $R^{OBJ}(\lambda)$ en au moins un point d'un objet (30) placé dans une zone se trouvant en face de et sensiblement perpendiculairement audit moyen (11) apte à émettre des couleurs et se trouvant dans le champ de vision dudit capteur électronique d'images couleurs (12) et étant soumis à un illuminant extérieur sous la forme d'un flux lumineux extérieur environnant noté $I^{ext}(\lambda)$, constant et inconnu, **caractérisé en ce qu'**il comporte des moyens pour :

• émettre une série de N illuminants $S^{SOURCE}(\lambda)_i$ avec N entier naturel strictement supérieur à un, i variant de 1 à N et $\lambda$, la longueur d'onde, $S^{SOURCE}(\lambda)_i$ étant connue en fonction des paramètres d'entrée dudit moyen (11) apte à émettre des flux lumineux de couleurs,
• capturer par ledit capteur électronique d'image couleur (12) du flux lumineux réfléchi en au moins un point dudit objet (30) et entrant dans le capteur, ledit flux lumineux étant noté $E^{capteur}(\lambda)_i$, avec N entier naturel strictement supérieur à deux, i variant de 1 à N et $\lambda$ la longueur d'onde, et
• obtenir N équations « $E_i$ »:

$$E^{capteur}(\lambda)_i = R^{OBJ}(\lambda)*(I^{ext}(\lambda)+S^{SOURCE}(\lambda)_i)$$

en raison du caractère additif de la lumière ondulatoire et par définition de la réflectance diffuse uniforme $R^{OBJ}(\lambda)$ en au moins un point de l'objet (30) ; et
• déterminer les deux fonctions inconnues continues $R^{OBJ}(\lambda)$ et $I^{ext}(\lambda)$ en résolvant le système des N équations $E_i$:

- en intégrant chaque équation $E_i$ sur l'intersection des spectres source et capteur, en notant x, y et z les sensibilités dans la base colorimétrique choisie, chaque équation $E_i$ générant alors trois équations « $E_i$ intégrée » :

$$\int E^{capteur}(\lambda)_i * x(\lambda) * d\lambda$$

$$= \int R^{OBJ}(\lambda) * (I^{ext}(\lambda) + S^{SOURCE}(\lambda)_i) * x(\lambda) * d\lambda$$

$$\int E^{capteur}(\lambda)_i * y(\lambda) * d\lambda$$

$$= \int R^{OBJ}(\lambda) * (I^{ext}(\lambda) + S^{SOURCE}(\lambda)_i) * y(\lambda) * d\lambda$$

$$\int E^{capteur}(\lambda)_i * z(\lambda) * d\lambda$$

$$= \int R^{OBJ}(\lambda) * (I^{ext}(\lambda) + S^{SOURCE}(\lambda)_i) * z(\lambda) * d\lambda$$

- en calculant la valeur numérique correspondant au terme de gauche des équations $E_i$ intégrée à l'aide des paramètres de sortie du capteur numérique d'image ; et
- en exprimant les deux fonctions inconnues continues $R^{OBJ}(\lambda)$ et $I^{ext}(\lambda)$ à l'aide d'un nombre fini de points, dit points d'interpolation, chaque point d'interpolation associant à une longueur d'onde $\lambda_i$ un paramètre $y_i$, les points d'interpolations étant reliés par au moins une fonction d'interpolation $s(\lambda)$ de type spline cubique scellée pour conserver le caractère continu desdites fonctions inconnues continues $R^{OBI}(\lambda)$ et $I^{ext}(\lambda)$, les $\lambda_i$ étant des longueurs d'onde choisies dans l'intersection des spectres source et capteur et étant des paramètres d'entrée du procédé, choisis pour minimiser le nombre de points d'interpolation à précision donnée ; et
- en recherchant les paramètres $y_i$ des fonctions $R^{OBJ}(\lambda)$ et $I^{ext}(\lambda)$ qui minimisent le système de moindres carrés $\|A * X - B\|_2$ résultant des équations $E_i$ intégrées avec X le vecteur regroupant les paramètres $y_i$ et A une matrice de Jacobi.

**Patentansprüche**

1. Verfahren zum Messen des gleichförmigen diffusen Reflexionsgrads $R^{OBJ}(\lambda)$ an mindestens einem Punkt eines Objekts (30) mittels einer Vorrichtung (10), umfassend eine Einrichtung (11), die geeignet ist, um Farblichtquellen zu emittieren, die in Form von Lichtströmen ausgedrückt werden, und einen elektronischen Farbbildsensor (12), **dadurch gekennzeichnet, dass** es die folgenden Schritte umfasst:

• Platzieren des Objekts (30) in einem Bereich, der sich vor und im Wesentlichen senkrecht zu der Einrichtung (11) befindet, die geeignet ist, um Farblichtquellen zu emittieren, die in Form von Lichtströmen ausgedrückt werden, und sich im Sichtfeld des elektronischen Farbbildsensors (12) befindet, wobei das Objekt (30) auch einer externen Lichtquelle in Form eines unbekannten und konstanten externen Umgebungslichtstroms (40) $I^{ext}(\lambda)$ ausgesetzt ist, wobei $\lambda$ die Wellenlänge bezeichnet, Emission einer Reihe von N Lichtquellen $S^{QUELLE}(\lambda)_i$ durch die Einrichtung (11), wobei N eine natürliche Zahl ist, die strikt größer als eins ist, i von 1 bis N variiert und $\lambda$ die Wellenlänge ist, wobei $S^{QUELLE}(\lambda)_i$ abhängig von den Eingangsparametern der Einrichtung (11) bekannt ist, die geeignet ist, um Farblichtströme zu emittieren, Erfassen des Lichtstroms, der an mindestens einem Punkt des Objekts (30) reflektiert wird und in den Sensor eintritt, durch den elektronischen Farbbildsensor (12), wobei der Lichtstrom als Sensor $E^{Sensor}(\lambda)_i$ bezeichnet wird, wobei N eine natürliche Zahl ist, die strikt größer als zwei ist, i von 1 bis N variiert und $\lambda$ die Wellenlänge ist, und Erlngen von N Gleichungen "$E_i$":

$$E^{Sensor}(\lambda)_i = R^{OBJ}(\lambda)*(I^{ext}(\lambda)+S^{QUELLE}(\lambda)_i)$$

aufgrund des additiven Charakters von wellenförmigem Licht und per Definition des einheitlichen diffusen Re-

flexionsgrads $R^{OBJ}(\lambda)$ an mindestens einem Punkt des Objekts (30); und
• Bestimmen durch die Vorrichtung (10) der zwei kontinuierlichen unbekannten Funktionen $R^{OBJ}(\lambda)$ und $I^{ext}(\lambda)$ durch Lösen des Systems der N Gleichungen $E_i$:

- durch Integrieren jeder Gleichung $E_i$ über den Schnittpunkt der Spektren von Quelle und Sensor, wobei x, y und z die Empfindlichkeiten in der gewählten kolorimetrischen Basis bezeichnen, wobei jede Gleichung $E_i$ dann drei Gleichungen "$E_i$ integriert" erzeugt:

$$\int E^{capteur}(\lambda)_i * x(\lambda) * d\lambda$$

$$= \int R^{OBJ}(\lambda) * (I^{ext}(\lambda) + S^{SOURCE}(\lambda)_i) * x(\lambda) * d\lambda$$

$$\int E^{capteur}(\lambda)_i * y(\lambda) * d\lambda$$

$$= \int R^{OBJ}(\lambda) * (I^{ext}(\lambda) + S^{SOURCE}(\lambda)_i) * y(\lambda) * d\lambda$$

$$\int E^{capteur}(\lambda)_i * z(\lambda) * d\lambda$$

$$= \int R^{OBJ}(\lambda) * (I^{ext}(\lambda) + S^{SOURCE}(\lambda)_i) * z(\lambda) * d\lambda$$

- durch Berechnen des numerischen Werts, der dem linken Term der integrierten $E_i$ Gleichungen entspricht, unter Verwendung der Ausgangsparameter des digitalen Bildsensors; und
- durch Ausdrücken der zwei kontinuierlichen unbekannten Funktionen $R^{OBJ}(\lambda)$ und $I^{ext}(\lambda)$ mittels einer endlichen Anzahl von Punkten, den sogenannten Interpolationspunkten, wobei jeder Interpolationspunkt einen Parameter $y_i$ mit einer Wellenlänge $\lambda_i$ assoziiert, wobei die Interpolationspunkte durch mindestens eine Interpolationsfunktion $s(\lambda)$ vom Typ versiegelter kubischer Spline verbunden sind, um den kontinuierlichen Charakter der kontinuierlichen unbekannten Funktionen $R^{OBJ}(\lambda)$ und $I^{ext}(\lambda)$ beizubehalten, wobei $\lambda_i$ Wellenlängen sind, die ausgewählt sind aus dem Schnittpunkt der Quell- und Sensorspektren liegen und Eingangsparameter des Verfahrens sind, die gewählt sind, um die Anzahl der Interpolationspunkte bei gegebener Genauigkeit zu minimieren; und
- durch Suchen der Parameter $y_i$ der Funktionen $R^{OBJ}(\lambda)$ und $I^{ext}(\lambda)$, die das System der kleinsten Quadrate $\|A * X - B\|_2$ minimieren, das aus den integrierten Gleichungen $E_i$ resultiert, wobei X der Vektor ist, der die Parameter $y_i$ zusammenfasst, und A eine Jacobi-Matrix ist.

2. Verfahren gemäß Anspruch 1, **dadurch gekennzeichnet, dass** es ferner einen Bestimmungsschritt des Werts der externen Lichtquelle $I^{ext}(\lambda)$ umfasst.

3. Verfahren nach Anspruch 1 oder 2, **dadurch gekennzeichnet, dass** die Anzahl an Blitzen in der gleichen Größenordnung ist wie die Anzahl der Interpolationspunkte, um die Werte des gleichförmigen diffusen Reflexionsgrads $R^{OBJ}(\lambda)$ an mindestens einem Punkt des Objekts und der externen Lichtquelle $I^{ext}(\lambda)$ zu bestimmen.

4. Verfahren nach Anspruch 1 oder 2, **dadurch gekennzeichnet, dass** es einen Bestimmungsschritt der Werte des gleichförmigen diffusen Reflexionsgrads $R^{OBJ}(\lambda)$ an mindestens einem Punkt des Objekts (30) und der externen Lichtquelle $I^{ext}(\lambda)$ in mehreren Spektralbändern umfasst.

5. Verfahren nach einem der vorherigen Ansprüche, **dadurch gekennzeichnet, dass** die Vorrichtung (10) einen Bildschirm zum Emittieren der Farbblitze und einen elektronischen Bildsensor zum Erfassen des von dem Zielobjekt reflektierten Lichts implementiert.

6. Verfahren nach einem der vorherigen Ansprüche, **dadurch gekennzeichnet, dass** die Vorrichtung (10) ein Fotoapparat oder eine Kamera mit integriertem oder abnehmbarem Blitz ist.

**7.** Verfahren nach einem der vorherigen Ansprüche, **dadurch gekennzeichnet, dass** die Vorrichtung (10) Wellenleiter einsetzt, um die Emission und den Empfang der Farbblitze durchzuleiten.

**8.** Verfahren nach einem der Ansprüche 1 bis 7, **dadurch gekennzeichnet, dass** es zur Erstellung spektrometrischer Fotografien von Objekten und zur Durchführung beliebiger Farbanpassungen implementiert wird.

**9.** Verfahren nach einem der Ansprüche 1 bis 7, **dadurch gekennzeichnet, dass** es zum Messen der Farbe eines Elements aus der folgenden Gruppe durchgeführt wird: Materialien, Feststoffe, Flüssigkeiten, Gase, Farben, Tapeten, Grafiken, Textilien, Kunststoffe, Holz, Metalle, Böden, Mineralien, Pflanzen und Lebensmittel.

**10.** Verfahren nach einem der Ansprüche 1 bis 7, **dadurch gekennzeichnet, dass** es zum Messen von Farben für medizinische oder kosmetische Zwecke am Menschen und am lebenden Objekt von mindestens einem Element aus der folgenden Gruppe durchgeführt wird: Haut, Pickel, Muttermale, Haare, Fell, Make-up und Zähne.

**11.** Verfahren nach einem der Ansprüche 1 bis 7, **dadurch gekennzeichnet, dass** es zur Verwendung von farbigen, ein- oder mehrdimensionalen Strichcodes durchgeführt wird.

**12.** Verfahren nach einem der Ansprüche 1 bis 7, **dadurch gekennzeichnet, dass** es zum Zweck der Unterstützung von farbenblinden und/oder blinden Menschen durchgeführt wird.

**13.** Vorrichtung (10), umfassend eine Einrichtung (11), die geeignet ist, um Farblichtquellen in Form von Farblichtströmen zu emittieren, und einem elektronischen Farbbildsensor (12) zum Messen des gleichförmigen diffusen Reflexionsvermögens $R^{OBJ}(\lambda)$ an mindestens einem Punkt eines Objekts (30), das in einem Bereich platziert ist, der sich gegenüber und im Wesentlichen senkrecht zu der Einrichtung (11) befindet, die geeignet ist, um Farben zu emittieren, und sich im Sichtfeld des elektronischen Farbbildsensors (12) befindet und einer äußeren Lichtquelle in Form eines konstanten und unbekannten, mit $I^{ext}(\lambda)$ bezeichneten äußeren Umgebungslichtstroms ausgesetzt ist, **dadurch gekennzeichnet, dass** es Einrichtungen zu Folgendem umfasst:

• emittieren einer Reihe von N Lichtquellen $S^{QUELLE}(\lambda)_i$, wobei N eine natürliche Zahl ist, die strikt größer ist als eins ist, i von 1 bis N variiert und $\lambda$ die Wellenlänge ist, $S^{QUELLE}(\lambda)_i$ abhängig von den Eingangsparametern der Einrichtung (11) bekannt ist, die geeignet ist, um Farblichtströme zu emittieren,
• Erfassen des Lichtstromes, der an mindestens einem Punkt des Objekts (30) reflektiert wird und in den Sensor eintritt, durch den elektronischen Farbbildsensor (12), wobei der Lichtstrom mit $E^{Sensor}(\lambda)_i$ bezeichnet wird, wobei N eine natürliche Zahl ist, die strikt größer als zwei ist, i von 1 bis N variiert und $\lambda$ die Wellenlänge ist, und
• Erlangen von n Gleichungen "$E_i$":

$$E^{Sensor}(\lambda)_i = R^{OBJ}(\lambda)^*(I^{ext}(\lambda)+S^{QUELLE}(\lambda)_i)$$

aufgrund des additiven Charakters von wellenförmigem Licht und per Definition des einheitlichen diffusen Reflexionsgrads $R^{OBJ}(\lambda)$ an mindestens einem Punkt des Objekts (30); und
• Bestimmen der zwei kontinuierlichen unbekannten Funktionen $R^{OBJ}(\lambda)$ und $I^{ext}(\lambda)$ durch Lösen des Systems der N Gleichungen $E_i$:

- durch Integrieren jeder Gleichung $E_i$ über den Schnittpunkt der Spektren von Quelle und Sensor, wobei x, y und z die Empfindlichkeiten in der gewählten kolorimetrischen Basis bezeichnen, wobei jede Gleichung $E_i$ dann drei Gleichungen "E, integriert" erzeugt:

$$\int E^{capteur}(\lambda)_i * x(\lambda) * d\lambda$$

$$= \int R^{OBJ}(\lambda) * (I^{ext}(\lambda) + S^{SOURCE}(\lambda)_i) * x(\lambda) * d\lambda$$

$$\int E^{capteur}(\lambda)_i * y(\lambda) * d\lambda$$

$$= \int R^{OBJ}(\lambda) * (I^{ext}(\lambda) + S^{SOURCE}(\lambda)_i) * y(\lambda) * d\lambda$$

$$\int E^{capteur}(\lambda)_i * z(\lambda) * d\lambda$$

$$= \int R^{OBJ}(\lambda) * (I^{ext}(\lambda) + S^{SOURCE}(\lambda)_i) * z(\lambda) * d\lambda$$

- durch Berechnen des numerischen Werts, der dem linken Term der integrierten $E_i$ Gleichungen entspricht, unter Verwendung der Ausgangsparameter des digitalen Bildsensors; und
- durch Ausdrücken der zwei kontinuierlichen unbekannten Funktionen $R^{OBJ}(\lambda)$ und $I^{ext}(\lambda)$ mittels einer endlichen Anzahl von Punkten, den sogenannten Interpolationspunkten, wobei jeder Interpolationspunkt einen Parameter $y_i$ mit einer Wellenlänge $\lambda_i$ assoziiert, wobei die Interpolationspunkte durch mindestens eine Interpolationsfunktion $s(\lambda)$ vom Typ versiegelter kubischer Spline verbunden sind, um den kontinuierlichen Charakter der kontinuierlichen unbekannten Funktionen $R^{OBJ}(\lambda)$ und $I^{ext}(\lambda)$ beizubehalten, wobei $\lambda_i$ Wellenlängen sind, die ausgewählt sind aus dem Schnittpunkt der Quell- und Sensorspektren liegen und Eingangsparameter des Verfahrens sind, die gewählt sind, um die Anzahl der Interpolationspunkte bei gegebener Genauigkeit zu minimieren; und
- durch Suchen der Parameter $y_i$ der Funktionen $R^{OBJ}(\lambda)$ und $I^{ext}(\lambda)$, die das System der kleinsten Quadrate $\|A * X - B\|_2$ minimieren, das aus den integrierten Gleichungen $E_i$ resultiert, wobei $\lambda_i$ der Vektor ist, der die Parameter $y_i$ zusammenfasst, und A eine Jacobi-Matrix ist.

## Claims

1. A method for measuring the uniform diffuse reflectance $R^{OBJ}(\lambda)$ at least at one point of an object (30) by using a device (10) comprising a means (11) capable of emitting coloured illuminants expressed in the form of luminous flux and an electronic colour image sensor (12), **characterized in that** it comprises the following steps:

· placing of the said object (30) in a zone located opposite and substantially perpendicular to the said means (11) capable of emitting coloured illuminants in the form of luminous fluxes of colours and located in the field of vision of the said electronic colour image sensor (12), the said object (30) also being subjected to an external illuminant in the form of a constant and unknown surrounding external luminous flux (40) $I^{ext}(\lambda)$, where $\lambda$ denotes the wavelength; emission by the said means (11) of a series of N illuminants $S^{source}(\lambda)_i$ with N being a natural number greater than one, i varying from 1 to N and $\lambda$ being the wavelength, $S^{source}(\lambda)_i$ being known as a function of the input parameters of the said means (11) capable of emitting luminous fluxes of colours, capture by the said electronic colour image sensor (12) of the luminous flux reflected at least at one point of the said object (30) and entering in the sensor, the said luminous flux being denoted as $E^{capteur}(\lambda)_i$, with N being a natural number strictly greater than two, i varying from 1 to N and $\lambda$ being the wavelength; and obtaining of N equations "$E_i$":

$$E^{capteur}(\lambda)_i = R^{OBJ}(\lambda) * ( I^{ext}(\lambda) + S^{source}(\lambda)_i )$$

due to the additive nature of the wave light and by definition of the uniform diffuse reflectance $R^{OBJ}(\lambda)$ at least at one point of the object (30); and
· determination by the said device (10) of the two unknown continuous functions $R^{OBJ}(\lambda)$ and $I^{ext}(\lambda)$ by solving the system of N equations $E_i$:

- by integrating each equation $E_i$ on the intersection of the source and sensor spectra, by denoting x, y and z the sensitivities in the colorimetric base selected, each equation $E_i$ then generating three "$E_i$ integrated" equations:

$$\int(E^{capteur}(\lambda)_i \, *x(\lambda) \, *d\lambda) - \int((R^{OBJ}(\lambda) \, *( \, I^{ext}(\lambda) + S^{source}(\lambda)_i \, ) \, *x(\lambda) \, *d\lambda)$$

$$\int(E^{capteur}(\lambda)_i \, *y(\lambda) \, *d\lambda) - \int((R^{OBJ}(\lambda) \, *( \, I^{ext}(\lambda) + S^{source}(\lambda)_i \, ) \, *y(\lambda) \, *d\lambda)$$

$$\int(E^{capteur}(\lambda)_i \, *z(\lambda) \, *d\lambda) - \int((R^{OBJ}(\lambda) \, *( \, I^{ext}(\lambda) + S^{source}(\lambda)_i \, ) \, *z(\lambda) \, *d\lambda),$$

- by calculating the numerical value corresponding to the left-hand side of the integrated equations $E_i$ with the use of the output parameters of the digital image sensor; and
- by expressing the two unknown continuous functions $R^{OBJ}(\lambda)$ and $I^{ext}(\lambda)$ with the use of a finite number of points, named interpolation points, each interpolation point associating to a wavelength $\lambda_j$ a parameter $y_j$; said interpolation points being connected by one interpolation function $s(\lambda)$ of the type of sealed cubic spline function $s(\lambda)$ for maintaining the continuous nature of the said unknown continuous functions $R^{OBJ}(\lambda)$ and $I^{ext}(\lambda)$, the $\lambda_j$ being wavelengths selected in the intersection of the source and sensor spectra and being input parameters of the method, chosen to minimize the number of interpolation points for a given precision; and
- by searching the parameters $y_j$ of the functions $R^{OBJ}(\lambda)$ and $I^{ext}(\lambda)$ that minimize the least squares system $\|A*X-B\|_2$ resulting from the $E_i$ integrated equations with X the vector grouping the parameters $y_j$ and A a Jacobi matrix.

2. A method according to claim 1, **characterized in that** it further includes a step of determining the value of the external illuminant $I^{ext}(\lambda)$.

3. A method according to claim 1 or 2, **characterized in that** the number of flashes is of the same order of magnitude as the number of interpolation points for determining the values of the uniform diffuse reflectance $R^{OBJ}(\lambda)$ at least at one point of the object (30) and of the external illuminant $I^{ext}(\lambda)$.

4. A method according to claim 1 or 2, **characterized in that** it includes a step of determining the values of the uniform diffuse reflectance $R^{OBJ}(\lambda)$ at least at one point of the object (30) and the external illuminant $I^{ext}(\lambda)$ in several spectral bands.

5. A method according to one of the preceding claims, **characterised in that** the said device (10) makes use of a screen for emitting flashes of colour and an electronic image sensor for sensing and capturing the light reflected by the target object.

6. A method according to any one of the preceding claims, **characterised in that** the said device (10) is a camera unit or a camera with in built or removable flash.

7. A method according to any one of the preceding claims, **characterized in that** the said device (10) implements waveguides for ensuring effective transiting of the emission and reception of flashes of colours.

8. A method according to any one of the preceding claims, **characterized in that** it is implemented in order to take spectrometric photographs of objects and to make chromatic adjustments at will.

9. A method according to one of the preceding claims, **characterized in that** it is implemented in order to measure the colour of an element included in the following group: materials, solids, liquids, gases, paintings, tapestries, graphics, textiles, plastics, woods, metals, soils, minerals, plants and foods.

10. A method according to one of claims 1 to 8, **characterized in that** it is implemented for the measurement of colours for medical or cosmetic purposes on human beings and living organisms of at least one element included in the following group: skin, pimples, moles, hair, fur, makeup, and teeth.

11. A method according to one of claims 1 to 8, **characterized in that** it is implemented for the use of colour barcodes, of one or more dimensions.

12. A method according to one of claims 1 to 8, **characterized in that** it is implemented with a view to assisting people having colour blindness and / or who are blind.

13. A device (10) comprising the means (11) capable of emitting colour illuminants in the form of luminous flux of colours and an electronic colour image sensor (12), for measuring the uniform diffuse reflectance $R^{OBJ}(\lambda)$ at least at one point of an object (30) placed in a zone located opposite and substantially perpendicular to the said means (11) capable of emitting colours and located in the field of vision of the said electronic colour image sensor (12), and also being subjected to an external illuminant in the form of a constant and unknown surrounding external luminous flux (40) denoted as $I^{ext}(\lambda)$, **characterized in that** it comprises the means for:

- emitting a series of N illuminants $S^{source}(\lambda)_i$ with N being a natural number greater than one, i varying from 1 to N and $\lambda$ being the wavelength, $S^{source}(\lambda)_i$ being known as a function of the input parameters of the said means (11) capable of emitting luminous fluxes of colours,

  capture by the said electronic colour image sensor (12) of the luminous flux reflected at least at one point of the said object (30) and entering in the sensor, the said luminous flux being denoted as $E^{capteur}(\lambda)_i$, with N being a natural number strictly greater than two, i varying from 1 to N and $\lambda$ being the wavelength; and obtaining of N equations "$E_i$" :

$$E^{capteur}(\lambda)_i = R^{OBJ}(\lambda) * ( I^{ext}(\lambda) + S^{source}(\lambda)_i )$$

  due to the additive nature of the wave light and by definition of the uniform diffuse reflectance $R^{OBJ}(\lambda)$ at least at one point of the object (30); and

- determination by the said device (10) of the two unknown continuous functions $R^{OBJ}(\lambda)$ and $I^{ext}(\lambda)$ by solving the system of N equations $E_i$:

  - by integrating each equation $E_i$ on the intersection of the source and sensor spectra, by denoting x, y and z the sensitivities in the colorimetric base selected, each equation $E_i$ then generating three "$E_i$ integrated" equations:

$$\int(E^{capteur}(\lambda)_i *x(\lambda) *d\lambda) - \int((R^{OBJ}(\lambda) *( I^{ext}(\lambda) + S^{source}(\lambda)_i ) *x(\lambda) *d\lambda)$$

$$\int(E^{capteur}(\lambda)_i *y(\lambda) *d\lambda) - \int((R^{OBJ}(\lambda) *( I^{ext}(\lambda) + S^{source}(\lambda)_i ) *y(\lambda) *d\lambda)$$

$$\int(E^{capteur}(\lambda)_i *z(\lambda) *d\lambda) - \int((R^{OBJ}(\lambda) *( I^{ext}(\lambda) + S^{source}(\lambda)_i ) *z(\lambda) *d\lambda),$$

  - by calculating the numerical value corresponding to the left-hand side of the integrated equations Ei with the use of the output parameters of the digital image sensor; and
  - by expressing the two unknown continuous functions $R^{OBJ}(\lambda)$ and $I^{ext}(\lambda)$ with the use of a finite number of points, named interpolation points, each interpolation point associating to a wavelength $\lambda_j$ a parameter $y_j$; said interpolation points being connected by one interpolation function $s(\lambda)$ of the type of sealed cubic spline function $s(\lambda)$ for maintaining the continuous nature of the said unknown continuous functions $R^{OBJ}(\lambda)$ and $I^{ext}(\lambda)$, the $\lambda_j$ being wavelengths selected in the intersection of the source and sensor spectra and being input parameters of the method, chosen to minimize the number of interpolation points for a given precision; and
  - by searching the parameters $y_j$ of the functions $R^{OBJ}(\lambda)$ and $I^{ext}(\lambda)$ that minimize the least squares system $\|A*X-B\|_2$ resulting from the $E_i$ integrated equations with X the vector grouping the parameters $y_j$ and A a Jacobi matrix.

Figure 1

Placement d'un objet dans une zone se trouvant en face de et sensiblement perpendiculairement à un moyen pour émettre des couleurs et se trouvant dans le champ de vision d'un capteur électronique d'image

$\downarrow$

Emission par ledit moyen pour émettre des couleurs d'une série de N illuminants $S^{source} (\lambda)_i$ (avec N entier naturel supérieur à un, et i variant entre 1 et N)

$\downarrow$

Capture par ledit capteur électronique d'image de la lumière réfléchie par ledit objet

$\downarrow$

Détermination par ledit dispositif de la valeur $R^{OBJ}(\lambda)$ de la couleur de l'objet à l'aide de la résolution d'une série d'équations du type $f^{capteur}$ ($R^{capteur}_i$, $G^{capteur}_i$, $B^{capteur}_i$, $BV^{capteur}_i$) $(\lambda) = R^{OBJ}(\lambda) \times [f^{source}$ ($R^{source}_i$, $G^{source}_i$, $B^{source}_i$, $BL^{source}_i$) $(\lambda) + I^{ext}(\lambda)$ ], où $f^{capteur}$ et $f^{source}$ sont des fonctions de transfert.

Figure 2

Spectre de perception de l'oeil
humain (avec les sensibilités de
l'observateur standard CIE 1931)

$\lambda 1^{CIE\ 1931}$
(380 nm)

$\lambda 2^{CIE\ 1931}$
(780 nm)

nm

Spectre de perception du
capteur (avec les sensibilités
des primaires du capteur)

$\lambda 1^{capteur}$

$\lambda 2^{capteur}$

nm

Spectre d'émission de la source
des flashs de couleurs (pour les
3 primaires de la source)

$\lambda 1^{source}$

$\lambda 2^{source}$

nm

Spectre de mesure pour $R^{OBJ}(\lambda)$
et $I^{ext}(\lambda)$ = intersection des
spectres source et capteur
(exemple avec les sensibilités
des primaires du capteur)

$\lambda 1^{mesure}$

$\lambda 2^{mesure}$

nm

Figure 3

EP 2 815 218 B1

Grille k=1
Pour N = 1,2,3

Les points 01,02,03 correspondent aux sommets du triangle de flashage.
Les coordonnées des points sont des coordonnées barycentriques dans le repère 01,02,03.

Figure 4

EP 2 815 218 B1

Grille k=2
Pour N = 4

Figure 5

EP 2 815 218 B1

Grille k=3
Pour N = 5,6

Les points 01,02,03 correspondent aux sommets du triangle de flashage.
Les coordonnées des points sont des coordonnées barycentriques dans le repère 01,02,03.

Figure 6

EP 2 815 218 B1

Grille k=4
Pour N = 7,...,10

(02) (0,1,0)

(09)
(1/6,2/3,1/6)

(0,1/2,1/2) (05)━━━━━━(06) (1/2,1/2,0)

(1/3,1/3,1/3)

(10)

(08)                    (07)
(1/6,1/6,2/3)          (2/3,1/6,1/6)

(03)━━━━━━(04)━━━━━━(01)
(0,0,1)   (1/2,0,1/2)   (1,0,0)

Les points 01,02,03 correspondent aux sommets du triangle de flashage.
Les coordonnées des points sont des coordonnées barycentriques dans le repère 01,02,03.

Figure 7

EP 2 815 218 B1

Les points 01,02,03 correspondent aux sommets du triangle de flashage. Les coordonnées des points sont des coordonnées barycentriques dans le repère 01,02,03.

Grille k=5
Pour N = 11,....,15

Figure 8

(0,1,0)
(1/4,3/4,0)
(1/2,1/2,0)
(3/4,1/4,0)
(1,0,0)
(0,3/4,1/4)
(1/4,1/2,1/4)
(1/2,1/4,1/4)
(3/4,0,1/4)
(0,1/2,1/2)
(1/4,1/4,1/2)
(1/2,0,1/2)
(0,1/4,3/4)
(1/4,0,3/4)
(0,0,1)

01 02 03 04 05 06 07 08 09 10 11 12 13 14 15

**EP 2 815 218 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5963333 A
- WO 2004079314 A
- GB 2474701 A

**Littérature non-brevet citée dans la description**

- **MASATO TSUKADA et al.** An approach to color constancy using multiples images. *IEEE 1990*
- **YUICHI OHTA et al.** Recovery of illuminant and surface colors from images based on the CIE daylight. *Lecture notes in Computer Science,* 1994
- **JIAN HO et al.** Separating a color signal into illumination and surface réflectance components : theory and applications. *IEEE 1990*
- **STEPHEN PARK et al.** Estimation of spectral réflectance curves from multispectral image data. *Applied Optics,* 1977